# FASCICULE DE BREVET EUROPEEN

(11) **EP 4 446 102 B1**
(45) Date de publication et mention de la délivrance du brevet: **03.12.2025**
(21) Numéro de dépôt: 24169535.2
(22) Date de dépôt: 10.04.2024
(51) Int. Cl.: B29D 11/00, B81C 1/00, G02B 3/00

(54) **PROCÉDÉ DE FABRICATION D'UNE STRUCTURE TRIDIMENSIONNELLE EN FLEXION**
VERFAHREN ZUR HERSTELLUNG EINER DREIDIMENSIONALEN BIEGESTRUKTUR
METHOD FOR PRODUCING A THREE-DIMENSIONAL STRUCTURE BY BENDING

(30) Priorité: 12.04.2023 FR 2303637
(43) Date de publication de la demande: 16.10.2024
(73) Titulaire: Commissariat à l'Energie Atomique et aux Energies Alternatives, 75015 Paris (FR)
(72) Inventeur: FEOUGIER, Raphaël, 38054 GRENOBLE Cedex09 (FR); POSSEME, Nicolas, 38054 GRENOBLE Cedex 09 (FR); TIRON, Raluca, 38054 GRENOBLE Cedex 09 (FR); ARGOUD, Maxime, 38054 GRENOBLE Cedex 09 (FR)
(74) Mandataire: Hautier IP

(56) Documents cités:
- WO-A2-01/77716
- US-A1- 2015 102 465
- ZHAO HANGBO ET AL: "Nanofabrication approaches for functional three-dimensional architectures", NANO TODAY, ELSEVIER, AMSTERDAM, NL, vol. 30, 20 December 2019 (2019-12-20), XP086041238, ISSN: 1748-0132, [retrieved on 20191220], DOI: 10.1016/J.NANTOD.2019.100825

## Description

### DOMAINE TECHNIQUE

La présente invention concerne le domaine des microstructures à trois dimensions (3D), plus exactement des microstructures présentant une déformation contrôlée. Elle trouve comme application particulièrement avantageuse le domaine des microlentilles.

### ETAT DE LA TECHNIQUE

Il existe plusieurs techniques de fabrication de microstructures 3D présentant une déformation contrôlée, notamment en vue de la fabrication de microlentilles. Les microlentilles sont généralement réalisées par lithographie optique suivie d'un fluage thermique, comme développé par Popovic, Z. D., Sprague, R. A., et Connell, G. A. N., dans la publication Technique for monolithic fabrication of microlens arrays, Applied Optics, 27(7):1281 (1988). Ces techniques peuvent poser des difficultés en termes de reproductibilité et de prévisibilité de la forme obtenue après fluage. D'autres techniques existent pour obtenir des réseaux de microlentilles, notamment la lithographie en nuance de gris (« grayscale » en anglais), de plus en plus étudiée pour la réalisation de structures 3D. La lithographie en nuance de gris implique souvent de nombreuses étapes de lithographie ce qui induit des budgets élevés. Une autre voie couramment utilisée est l'impression de motifs 3D. Cette technique utilise un moule structuré en micro-bols obtenu par lithographie optique et/ou par gravure. Ces motifs sont ensuite imprimés dans une résine, formant ainsi des microlentilles. La réalisation du moule peut s'avérer délicate lorsque les dimensions que l'on souhaite obtenir sont faibles.

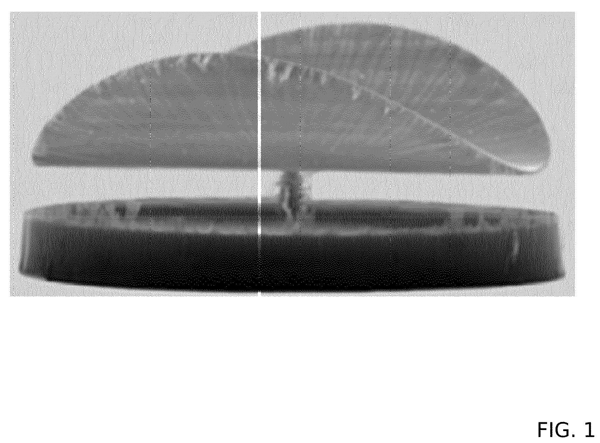

Dans un domaine éloigné de celui de la réalisation des microlentilles, il a été remarqué que les microdisques utilisés en photonique en tant que résonateurs bidimensionnels à mode de galeries (en anglais « whispering-gallery ») pouvaient se déformer lors de leur libération du substrat sous l'effet de la relaxation des contraintes, et prendre une forme de chips (voir notamment Li Y. et al, Three-Dimensional Anisotropic Microlaser from GaN-Based Self-Bent-Up Microdisk, ACS Photonics 2018, 5, 11, 4259-4264, 2018, dont une des figures est reproduite en figure 1). Cependant, la forme du microdisque après déformation dépend entièrement de ses contraintes propres et ne peut être contrôlée. On connaît également le document US 2015/102465 A1, proposant une méthode de fabrication de couches suspendues. Il apparaît que les couches suspendues obtenues présentent de façon fortuite des zones de déformations locales. Ces déformations ne sont toutefois pas contrôlées et ne permettent pas d'obtenir une forme globalement homogène : les déformations obtenues sont dans certaines zones tournées vers le substrat, et dans d'autres zones tournées à l'opposé. Le procédé présenté dans ce document ne permet donc pas la formation contrôlée de microstructures à trois dimensions, et notamment pas des microlentilles.

Un objectif de la présente invention est donc de proposer une méthode de déformation de microstructures, tout particulièrement de microlentilles, permettant de maîtriser la forme finale de la structure de manière reproductible et en induisant un budget limité.

Par ailleurs, la méthode de déformation d'un microdisque sous l'effet de la relaxation des contraintes suite à sa libération du substrat telle que décrite dans l'art antérieur ne permet sa déformation que dans un seul sens de flexion, ce sens de flexion étant induit par les contraintes régnant dans le microdisque. Un autre objectif de l'invention est de proposer une solution commune à une déformation en traction et à une déformation en compression.

### RESUME

Pour atteindre cet objectif, selon un mode de réalisation on prévoit un procédé de fabrication d'une structure tridimensionnelle comprenant les étapes suivantes :
a. une fourniture d'un empilement comprenant au moins, empilés selon une direction dite verticale :
   i. un substrat support,
   ii. une couche sacrificielle,
   iii. une couche d'intérêt délimitée dans toutes les directions d'un plan perpendiculaire à la direction verticale, dit plan horizontal, par un flanc,
   iv. une couche tenseur délimitée dans toutes les directions du plan horizontal par un flanc, la couche tenseur présentant une contrainte résiduelle σ₁₀₀,
b. un retrait d'une portion de la couche sacrificielle, dite portion de retrait, sélectivement à la couche d'intérêt et à la couche tenseur, la portion de retrait formant un contour fermé en projection dans le plan horizontal, la portion de retrait étant entièrement située au droit d'une portion latérale de la couche d'intérêt s'étendant depuis l'intégralité du flanc de la couche d'intérêt, le retrait de la portion de retrait étant effectué de sorte à conserver une portion de la couche sacrificielle, dite portion restante, située au droit de la couche d'intérêt et de la couche sacrificielle.

La contrainte résiduelle σ₁₀₀ de la couche tenseur est configurée pour provoquer une flexion de la couche d'intérêt lors de l'étape de retrait de la portion de retrait. Avantageusement, la contrainte résiduelle σ₁₀₀ est configurée pour provoquer la flexion de l'ensemble de la couche d'intérêt selon un unique sens de flexion lors de l'étape de retrait de la portion de retrait. Cet unique sens de flexion peut soit correspondre à un rapprochement de l'ensemble de la couche d'intérêt vers le substrat support, soit correspondre à un éloignement de l'ensemble de la couche d'intérêt vers le substrat support.

Dans ce procédé, le retrait de la portion de retrait de la couche sacrificielle permet la libération mécanique partielle de la couche d'intérêt et de la couche tenseur. La présence de la couche tenseur et ses propriétés mécaniques permettent de contraindre la couche d'intérêt dans une forme donnée lors de la libération. Les caractéristiques de la couche tenseur et notamment sa contrainte résiduelle peuvent être paramétrées de sorte à forcer la couche d'intérêt selon une forme souhaitée. Il est donc possible, grâce à l'utilisation de la couche tenseur, de contrôler très exactement la forme de la structure obtenue en fin de procédé.

Comme il sera présenté plus avant, à la fois le sens et l'amplitude de la déformation de la couche d'intérêt induits par le procédé selon l'invention peuvent être définis avec précisions et prédis par simulations numériques, ce qui permet de faciliter encore le contrôle de la déformation.

Ainsi, l'invention permet d'obtenir des structures en trois dimensions, tout particulièrement de microlentilles, avec une bonne maîtrise de la forme finale, de manière reproductible et tout en induisant un budget limité.

Un autre aspect de l'invention concerne un procédé de fabrication d'une structure tridimensionnelle présentant une symétrie de révolution selon la direction verticale. Le procédé comprend les étapes suivantes :
a. une fourniture d'un empilement comprenant, empilés selon une direction dite verticale :
   i. un substrat support,
   ii. une couche sacrificielle,
   iii. une couche d'intérêt délimitée dans toutes les directions d'un plan perpendiculaire à la direction verticale, dit plan horizontal, par un flanc présentant une symétrie de révolution selon la direction verticale,
   iv. une couche tenseur délimitée dans toutes les directions du plan horizontal par un flanc présentant une symétrie de révolution selon la direction verticale, la couche tenseur présentant une contrainte résiduelle σ₁₀₀,
b. un retrait d'une portion de la couche sacrificielle, dite portion de retrait, sélectivement à la couche d'intérêt et à la couche tenseur, la portion de retrait formant un contour fermé en projection dans le plan horizontal, la portion de retrait étant située au droit d'une portion latérale de la couche d'intérêt s'étendant depuis l'intégralité du flanc de la couche d'intérêt, le retrait de la portion de retrait étant effectué de sorte à conserver une portion de la couche sacrificielle, dite portion restante, située au droit de la couche d'intérêt et de la couche sacrificielle.

La contrainte résiduelle σ₁₀₀ de la couche tenseur est configurée pour provoquer une flexion de la couche d'intérêt lors de l'étape de retrait de la portion de retrait.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1, extraite de l'art antérieur, illustre une couche ayant subi une déformation suite à une relaxation de ses contraintes.
Les figures 2A à 2M représentent un premier mode de réalisation du procédé selon l'invention. La figure 2A illustre la fourniture d'un empilement initial comprenant un substrat support, une couche sacrificielle et une couche d'intérêt.
La figure 2B illustre le dépôt d'une couche tenseur sur la couche d'intérêt.
La figure 2C illustre le dépôt d'une couche de masquage sur la couche tenseur.
La figure 2D illustre la structuration de la couche de masquage selon un motif choisi.
La figure 2E illustre le transfert du motif à la couche tenseur au travers de la couche de masquage.
La figure 2F illustre le transfert du motif à la couche d'intérêt au travers de la couche de masquage.
La figure 2G illustre le retrait de la couche de masquage.
Les figures 2H à 2J illustrent le retrait progressif d'une portion de retrait de la couche sacrificielle tout en laissant en place une portion restante.
La figure 2K illustre la flexion de la couche d'intérêt et de la couche tenseur suite à leur libération grâce à l'étape de retrait.
La figure 2L illustre le retrait de la couche tenseur.
La figure 2M illustre un substrat sous-tendant une pluralité de structures 3D formées par le procédé selon l'invention.
La figure 2N est une vue de dessous de la portion restante et de la couche d'intérêt dans le cas où ces dernières présentent une forme circulaire.
La figure 2O est une vue de dessous de la portion restante et de la couche d'intérêt dans le cas où ces dernières présentent une forme elliptique.
La figure 2P est une vue en coupe de l'empilement avant et après déformation.
Les figures 3A à 3O représentent un deuxième mode de réalisation du procédé selon l'invention. La figure 3A illustre la fourniture d'un empilement initial comprenant un substrat support, une couche sacrificielle et une couche d'intérêt.
La figure 3B illustre la nanostructuration de la couche d'intérêt.
La figure 3C illustre le dépôt d'une couche de planarisation sur la couche d'intérêt.
La figure 3D illustre le dépôt d'une couche tenseur sur la couche de planarisation.
La figure 3E illustre le dépôt d'une couche de masquage sur la couche tenseur.
La figure 3F illustre la structuration de la couche de masquage selon un motif choisi.
La figure 3G illustre le transfert du motif à la couche tenseur au travers de la couche de masquage.
La figure 3H illustre le transfert du motif à la couche de planarisation et à la couche d'intérêt au travers de la couche de masquage.
La figure 3I illustre le retrait de la couche de masquage.
Les figures 3J à 3L illustrent le retrait progressif d'une portion de retrait de la couche sacrificielle tout en laissant en place une portion restante.
La figure 3M illustre la flexion de la couche d'intérêt et de la couche tenseur suite à leur libération grâce à l'étape de retrait.
La figure 3N illustre le retrait de la couche tenseur.
La figure 3O illustre le retrait de la couche de planarisation.
Les figures 4A à 4L représentent un troisième mode de réalisation du procédé selon l'invention. La figure 4A illustre la fourniture d'un empilement initial comprenant un substrat support, une couche sacrificielle et une couche d'intérêt.
La figure 4B illustre le dépôt d'une couche tenseur sur la couche d'intérêt.
La figure 4C illustre le dépôt d'une couche d'intérêt secondaire sur la couche tenseur.
La figure 4D illustre la nanostructuration de la couche d'intérêt secondaire.
La figure 4E illustre le dépôt d'une couche de masquage sur la couche d'intérêt secondaire.
La figure 4F illustre la structuration de la couche de masquage selon un motif choisi.
La figure 4G illustre le transfert du motif à la couche d'intérêt secondaire, à la couche tenseur et à la couche d'intérêt au travers de la couche de masquage.
La figure 4H illustre le retrait de la couche de masquage.
Les figures 4I à 4K illustrent le retrait progressif d'une portion de retrait de la couche sacrificielle tout en laissant en place une portion restante.
La figure 4L illustre la flexion de la couche d'intérêt, de la couche tenseur et de la couche d'intérêt secondaire suite à leur libération grâce à l'étape de retrait.
La figure 5 représente le profil de la couche d'intérêt après retrait de la couche sacrificielle pour différents diamètres du plot.
La figure 6A représente le profil de la couche d'intérêt au fur et à mesure du retrait de la portion de retrait de la couche sacrificielle, pour une couche d'intérêt et une couche tenseur présentant un diamètre de 15 µm.
La figure 6B est un cliché par microscopie électronique à balayage (MEB) du même ensemble qu'en figure 6A, après retrait complet de la portion de retrait de la couche sacrificielle.
La figure 7A représente le profil de la couche d'intérêt au fur et à mesure du retrait de la portion de retrait de la couche sacrificielle, pour une couche d'intérêt et une couche tenseur présentant un diamètre de 20 µm.
Les figures 7B à 7D sont des clichés par microscopie électronique à balayage (MEB) du même ensemble qu'en figure 7A, après retrait complet de la portion de retrait de la couche sacrificielle.
La figure 8A illustre les résultats expérimentaux (traits pleins) et théoriques (traits pointillés) du profil de la couche d'intérêt obtenus pour différents diamètres de plots résiduels.
La figure 8B illustre la déflexion maximale obtenue en fonction du diamètre du plot résiduel par simulations numériques (points carrés) et expérimentalement (points triangulaires).

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le retrait de la portion de retrait est effectué de sorte à mettre à nu la portion latérale de la couche d'intérêt.

Selon un mode de réalisation avantageux, le flanc de la couche d'intérêt et le flanc de la couche tenseur présentent chacun une forme sensiblement elliptique ou sensiblement circulaire en projection dans le plan horizontal.

Selon un mode de réalisation avantageux, la portion restante présente un flanc présentant une forme sensiblement elliptique ou sensiblement circulaire en projection dans le plan horizontal.

Selon un exemple préférentiel, le flanc de la couche d'intérêt, le flanc de la couche tenseur et le flanc de la portion restante présentent chacun une forme sensiblement circulaire en projection dans le plan horizontal. La couche d'intérêt présente un diamètre D200 dans le plan horizontal et la portion restante présente un diamètre D360 dans le plan horizontal. Après le retrait de la portion de retrait, la couche d'intérêt présente une flèche f200, avec f₂₀₀≥0,05*(D₂₀₀-D₃₆₀), de préférence f₂₀₀≥0,10*(D₂₀₀-D₃₆₀).

Selon un exemple avantageux, la couche d'intérêt présente un diamètre D₂₀₀ dans le plan horizontal et la portion restante présente un diamètre D₃₆₀ dans le plan horizontal. Après le retrait de la portion de retrait, le rapport D₂₀₀/D₃₆₀ est supérieur à 2, de préférence supérieur à 3.

Selon un exemple préférentiel, le flanc de la couche d'intérêt, le flanc de la couche tenseur et le flanc de la portion restante présentent chacun une forme sensiblement elliptique en projection dans le plan horizontal. La couche d'intérêt présente un petit axe D_{200,y} dans le plan horizontal et la portion restante présente un petit axe D_{360,y} dans le plan horizontal. Après le retrait de la portion de retrait, la couche d'intérêt présente, en coupe selon un plan perpendiculaire au plan horizontal et contenant le petit axe de la couche d'intérêt, une flèche f₂₀₀, avec f₂₀₀≥0,05*(D_{200,y}-D_{360,y}), de préférence f₂₀₀≥0,10*(D_{200,y}-D_{360,y}).

De préférence, la flèche f₂₀₀ de la couche d'intérêt après le retrait de la portion de retrait est supérieure à 100 nm, de préférence supérieure à 200 nm et même selon certains modes de réalisation supérieure à 500 nm. Cela peut être le cas quelle que soit la forme de la couche d'intérêt, notamment circulaire ou elliptique.

Préférentiellement, au moins lors de l'étape de retrait, le flanc de la couche tenseur est dans le prolongement du flanc de la couche d'intérêt selon la direction verticale.

Avantageusement, le procédé comprend en outre, après l'étape de retrait de la portion de retrait, une étape de retrait de la couche tenseur.

Selon un exemple, la flexion de la couche d'intérêt rapproche son flanc du substrat.

Avantageusement, le procédé est configuré de sorte que la flexion de la couche d'intérêt provoque le contact de la couche d'intérêt avec le substrat support.

De préférence, le procédé comprend le collage d'une partie au moins de la couche d'intérêt avec le substrat support.

De préférence, le collage d'une partie au moins de la couche d'intérêt avec le substrat support est provoqué au moins en partie, et de préférence uniquement, par la mise en contact de la couche d'intérêt avec le substrat support.

Selon un exemple, la flexion de la couche d'intérêt éloigne son flanc du substrat.

Selon un exemple, la couche d'intérêt présente une épaisseur e₂₀₀ selon la direction verticale avec e₂₀₀≤300 nm. Cela permet de limiter la contrainte résiduelle nécessaire dans la couche tenseur pour permettre une déformation de la couche d'intérêt. Cela permet également de réduire la rigidité de la couche d'intérêt.

Selon un exemple, lequel |σ₁₀₀| >500 MPa et de préférence |σ₁₀₀| >1000 MPa. Cela permet de garantir une déformation significative de la couche d'intérêt
Selon un exemple préféré, avant l'étape de retrait, la couche d'intérêt présente une contrainte résiduelle σ₂₀₀ avec |σ₂₀₀| ≤100 MPa. Cela permet de limiter la contrainte résiduelle nécessaire dans la couche tenseur pour permettre une déformation de la couche d'intérêt. Cela permet notamment de pouvoir atteindre des déformations de la couche d'intérêt de plusieurs nanomètres voire micromètres.

Selon un exemple, la couche sacrificielle est à base d'au moins l'un parmi un oxyde tel que le SiO₂ ou le SiON ou un nitrure tel que le SiN. La couche sacrificielle peut également être une couche anti-réfléchissante à base de silicium (désigné en anglais par le sigle SiARC, « Silicon containing Anti-Reflective Coating »). La couche sacrificielle est avantageusement retirable par gravure au HF ou au H₃PO₄. Dans le cas d'une couche sacrificielle à base d'un nitrure tel que le SiN, afin de faciliter le retrait au HF, le nitrure en question pourra avantageusement être déposé à basse température, par exemple à une température inférieure à 500°C, ou encore être oxygéné.

Selon un exemple, la couche tenseur est à base d'au moins l'un parmi le TiN, l'AIN, le SiN et le Si₃N₄. Avantageusement, la couche tenseur est à base d'un métal.

Selon un exemple, la couche d'intérêt est à base d'au moins l'un parmi le Si et le SiGe. Avantageusement, la couche d'intérêt est à base d'un matériau conducteur.

Selon un exemple, la couche d'intérêt est à base d'un matériau amorphe. Cela permet de s'affranchir des variations de propriétés physiques intrinsèques liées aux directions cristallines. Cela permet donc d'homogénéiser la déformation.

Selon un mode de réalisation préféré, la couche d'intérêt, après l'étape de retrait de la portion de retrait de la couche sacrificielle, forme une lentille.

Selon un mode de réalisation préféré, l'empilement comprend une pluralité de couches d'intérêt distinctes les unes des autres et contenues dans un même plan parallèle au plan horizontal avant l'étape de retrait de la portion de retrait de la couche sacrificielle.

Selon un exemple, l'empilement comprend une pluralité de couches d'intérêt distinctes les unes des autres et surmontant un unique substrat.

De préférence, chaque couche d'intérêt forme une lentille.

Selon un mode de réalisation, le procédé comprend, préalablement à l'étape de retrait de la portion de retrait de la couche sacrificielle, une étape de structuration de l'au moins une couche d'intérêt.

De préférence, l'étape de structuration de l'au moins une couche d'intérêt est effectuée avant l'étape de fourniture de l'empilement.

Selon un mode de réalisation, l'empilement comprend en outre une couche d'intérêt secondaire au-dessus de la couche tenseur, le retrait de la portion de retrait se fait également sélectivement à la couche d'intérêt secondaire, et le procédé comprend en outre, préalablement à l'étape de retrait de la portion de retrait, une étape de structuration de la couche d'intérêt secondaire.

Selon un exemple, l'étape de structuration comprend la mise en œuvre d'au moins une technique parmi la lithographie optique, l'autoassemblage de copolymères à blocs et la nanoimpression.

Les contraintes résiduelles régnant dans certains matériaux et dont il est fait mention dans la présente demande sont induites par les différentes étapes de dépôt et transformation de ces matériaux. Les contraintes résiduelles dans une couche peuvent être d'origine mécanique et notamment être générées lors de sa formation. Elles sont alors souvent liées aux méthodes et conditions de dépôt. Les contraintes résiduelles peuvent également être d'origine thermique. Elles dépendent alors des variations thermiques subies par la couche, de ses propriétés thermiques ainsi que de celles du substrat sur lequel elle repose. Cette composante thermique peut donc évoluer au cours des étapes de fabrication.

Diverses méthodes peuvent être utilisées afin de mesurer la contrainte résiduelle régnant dans une couche. On a typiquement recours à la diffraction de rayon X (DRX). En adaptant la longueur d'onde des rayons X émis en fonction du matériau étudié et en étudiant la répartition angulaire des rayons x diffractés par l'échantillon, on peut tracer une courbe reliant la distance inter-réticulaire d à l'angle mesuré et aux propriétés χ du matériaux (courbe typiquement du type d=sin²(χ)). La courbe ainsi obtenue permet de déterminer l'état et le niveau de contrainte de l'échantillon dans la direction mesurée. La contrainte résiduelle peut également être mesurée par interférométrie laser. Dans ce cas, le rayon de courbure du substrat soutenant la couche dont on souhaite connaître le niveau de contrainte résiduelle est mesuré avant et après le dépôt de la couche (ou avant et après une étape de traitement de la couche). Les valeurs de contrainte mécanique sont calculées directement en utilisant la formule de Stoney, en connaissant l'épaisseur de la couche et du substrat, leurs modules d'Young et leurs coefficients de Poisson respectifs. Par ailleurs, le niveau de contrainte résiduelle peut être mesuré par spectroscopie Raman, technique basée sur les variations des fréquences Raman des phonons optiques. Cette technique présente les avantages d'être non destructive, très sensible et de présenter une résolution spatiale sub-nanométrique.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant, soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi un matériau à base d'un matériau III-N peut comprendre un matériau III-N additionné de dopants.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. La sélectivité entre A et B est notée SA:B.

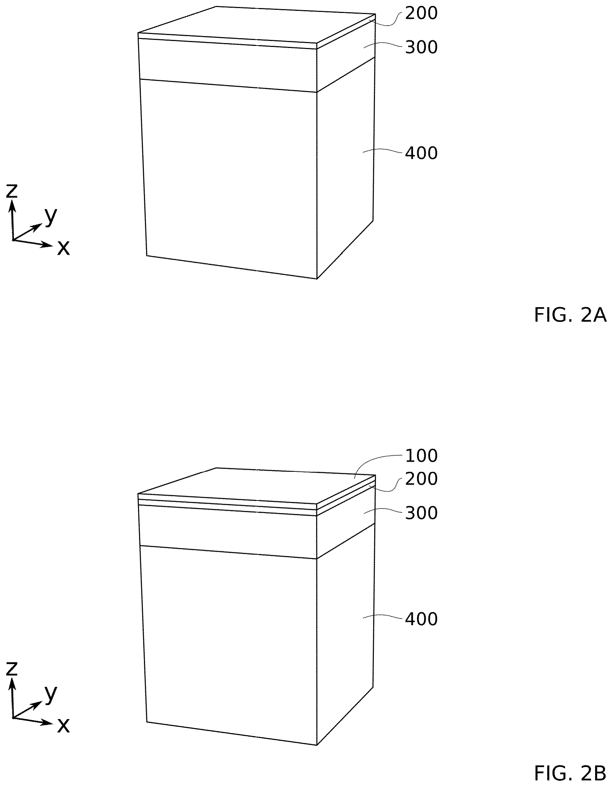

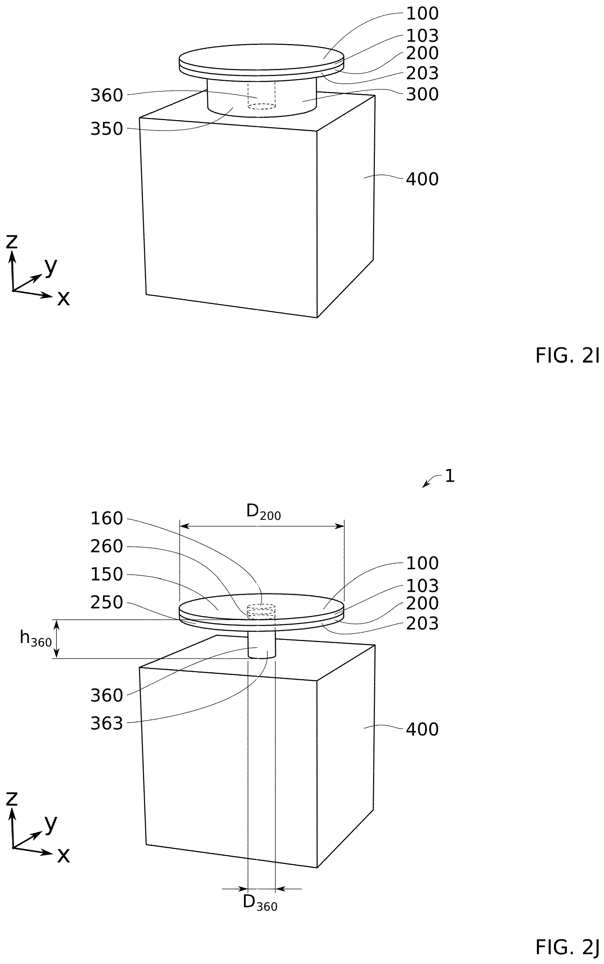

Un repère, de préférence orthonormé, comprenant les axes X, Y, Z est représenté en figures 2A, 3A et 4A. Ce repère est applicable par extension aux autres figures.

Dans la présente demande de brevet, on parlera préférentiellement d'épaisseur pour une couche et de hauteur pour une structure ou un dispositif. La hauteur est prise perpendiculairement au plan horizontal XY. L'épaisseur est prise selon une direction normale au plan d'extension principal de la couche. Ainsi, une couche présente typiquement une épaisseur selon Z, lorsqu'elle s'étend principalement le long du plan horizontal XY, et un élément en saillie, par exemple une tranchée d'isolation, présente une hauteur selon Z. Les termes relatifs « sur », « sous », « sous-jacent » se réfèrent préférentiellement à des positions prises selon la direction Z.

Les termes « sensiblement », « environ », « de l'ordre de » signifient « à 10% près, de préférence à 5% près ».

Un premier mode de réalisation d'une structure tridimensionnelle va être décrit en référence aux figures 2A à 2M. Pour des raisons de clarté les étapes 2A à 2L illustrent l'obtention d'une seule structure tridimensionnelle. Naturellement ces étapes permettent d'obtenir simultanément de nombreuses structures tridimensionnelles à partir d'un même substrat comme l'illustre la figure finale 2M.

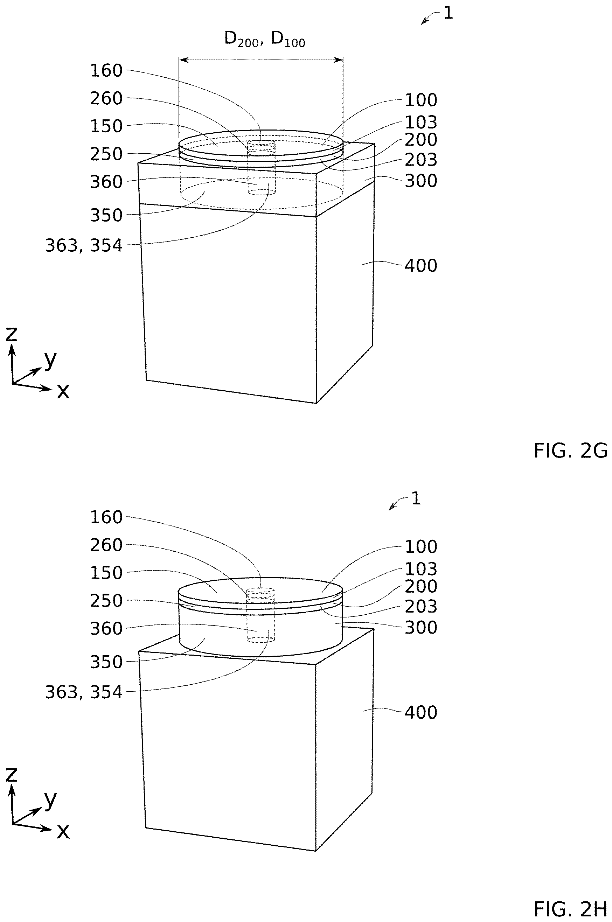

Les figures 2A à 2G illustrent une séquence d'étapes permettant d'obtenir un empilement 1, illustré à la figure 2G, qui va faire l'objet du procédé selon l'invention.

La figure 2A illustre la fourniture d'un empilement initial comprenant un substrat support 400, une couche sacrificielle 300 et une couche d'intérêt 200. De préférence, la couche d'intérêt 200 est au contact de la couche sacrificielle 300. Il est cependant envisageable qu'une autre couche s'intercale selon la direction verticale Z entre la couche sacrificielle 300 et la couche d'intérêt 200.

Une couche tenseur 100 est ensuite déposée sur, de préférence directement sur, la couche d'intérêt 100, comme illustré à la figure 2B. La couche tenseur 100 est typiquement déposée à basse température, par exemple à une température inférieure à 250°C pour un dépôt de TiN sur un SOC (« System On Chip », en français système sur puce).

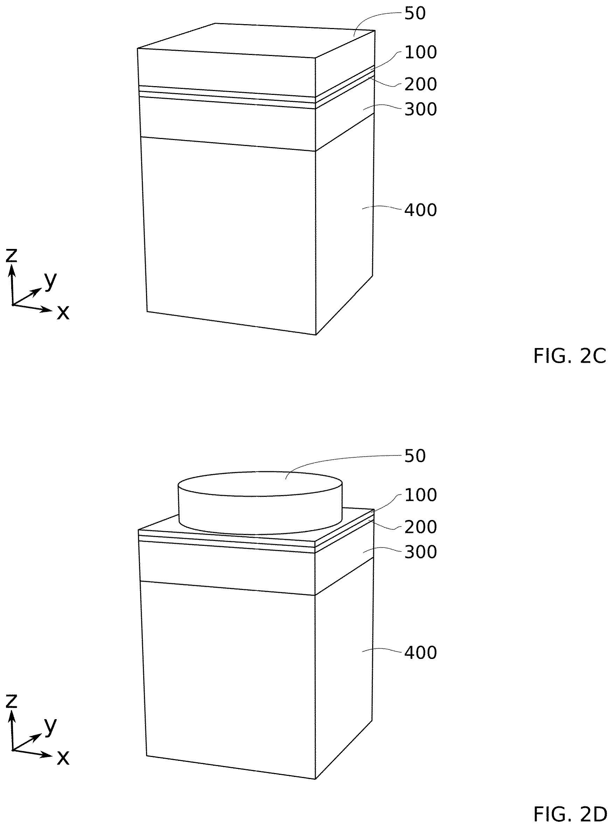

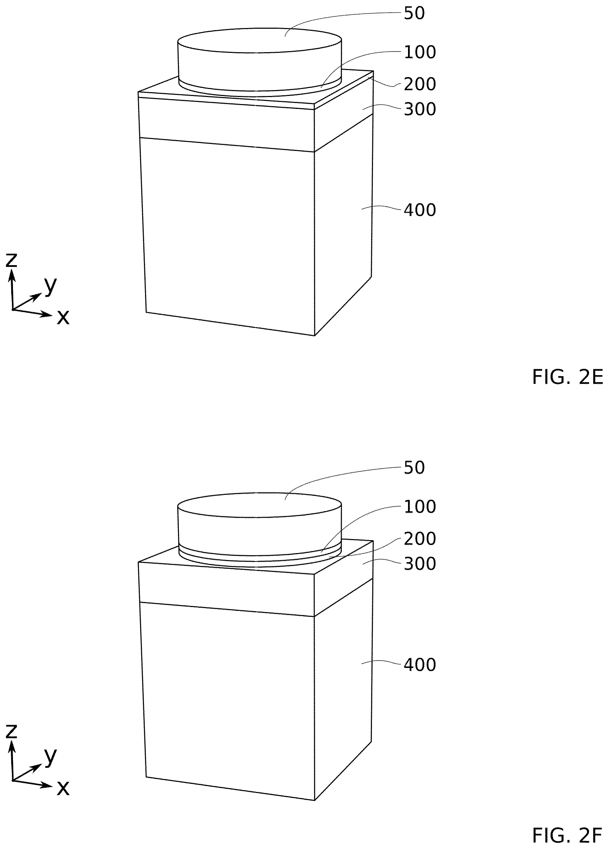

Les figures 2C à 2H illustrent une première structuration de l'empilement obtenu en figure 2B, par exemple par lithographie. Cette première structuration peut être qualifiée de microstructuration. Une couche de masquage 50 est tout d'abord déposée sur la couche tenseur 100, puis elle est elle-même structurée, par exemple par photolithographie, comme illustré à la figure 2D. La couche de masquage 50 est typiquement une résine photosensible. Il est ensuite procédé à une gravure de la couche tenseur 100 (figure 2E) puis de la couche d'intérêt 200 (figure 2F) et éventuellement de la couche sacrificielle 300 au travers de la couche de masquage 50. Ces étapes de gravure sont de préférence réalisées par une méthode de gravure anisotrope telle qu'une gravure ionique réactive ou une gravure plasma. La couche de masquage 50 est ensuite retirée, par exemple par décapage (ou en anglais « stripping ») (figure 2G).

On obtient ainsi l'empilement 1 illustré à la figure 2G et qui est fourni lors de la première étape du procédé selon l'invention.

Cet empilement 1 est décrit plus en détails ci-dessous.

L'empilement 1 comprend, empilé selon la direction verticale Z, le substrat support 400, la couche sacrificielle 300, la couche d'intérêt 200 et la couche tenseur 100. La couche d'intérêt 200 et la couche tenseur 100 présentent chacune un flanc 203, 103 les délimitant dans le plan horizontal XY.

Préférentiellement, la couche tenseur 100 recouvre entièrement la couche d'intérêt 200. Avantageusement, la couche d'intérêt 200 et la couche tenseur 100 présentent la même forme en projection dans le plan horizontal XY. De préférence, la couche d'intérêt 200 et la couche tenseur 100 se superposent en projection dans le plan horizontal XY. Autrement dit, le flanc 103 de la couche tenseur est de préférence dans le prolongement du flanc 203 de la couche d'intérêt 200 selon la direction verticale Z.

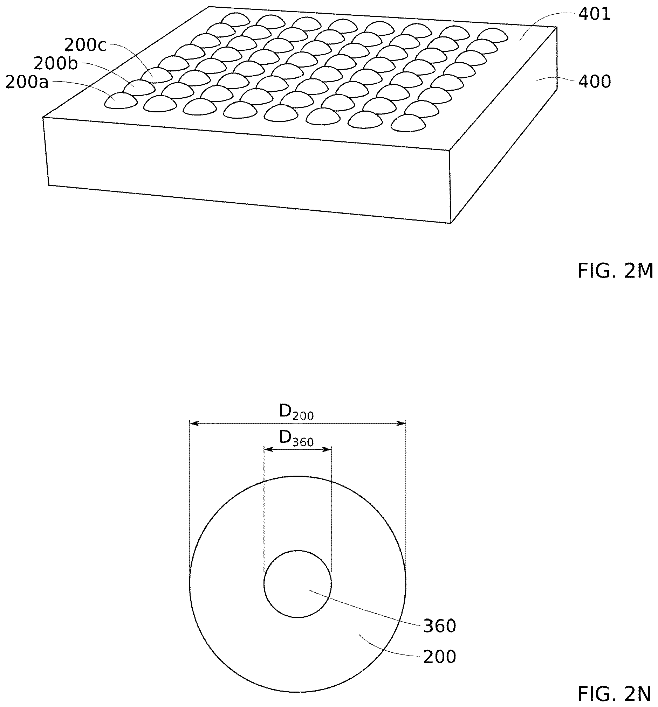

Selon un mode de réalisation préféré, le flanc 203 de la couche d'intérêt 200 présente une forme sensiblement circulaire en projection dans le plan horizontal XY (figure 2N). Autrement dit, en projection dans le plan horizontal, la couche d'intérêt 200 présente la forme d'un disque. La forme circulaire est particulièrement adaptée à la réalisation de lentilles voire de microlentilles à partir de la couche d'intérêt 200. Il est entendu cependant que ces couches peuvent prendre n'importe quelle forme en projection dans le plan horizontal XY, en fonction des applications visées.

De la même manière, selon un mode de réalisation préféré, le flanc 103 de la couche tenseur 100 présente une forme sensiblement circulaire en projection dans le plan horizontal XY. Autrement dit, en projection dans le plan horizontal, la couche tenseur 100 présente la forme d'un disque.

Lorsque le flanc 203 de la couche d'intérêt 200 présente, en projection dans le plan horizontal XY, une forme sensiblement circulaire, on définit un diamètre de la couche d'intérêt 200 noté D₂₀₀. De la même façon, lorsque le flanc 103 de la couche tenseur 210 présente, en projection dans le plan horizontal XY, une forme sensiblement circulaire, on définit un diamètre de la couche tenseur 100 noté D₁₀₀.

La structuration de la couche d'intérêt 200 pour définir son flanc 203 est de préférence qualifiée de microstructuration. Typiquement, D₂₀₀ <1000 µm (10⁻⁶ mètres) et de préférence D₂₀₀ <100 µm, de préférence D₂₀₀ <10 µm et de préférence D₂₀₀ <5 µm. Par ailleurs, de préférence D₂₀₀ > 20 nanomètres.

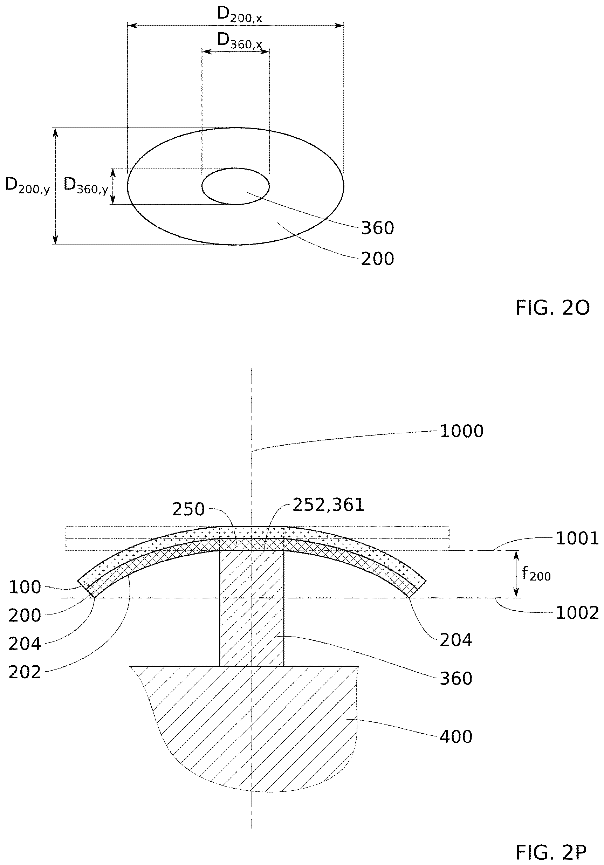

La couche d'intérêt 200 et la couche tenseur 100 peuvent également présenter, en projection dans le plan horizontal XY, une forme sensiblement elliptique (figure 2O). On définit alors pour la couche d'intérêt 200 un petit axe D_{200,y} de la couche d'intérêt 200 et un grand axe D_{200,x} de la couche d'intérêt 200, et pour la couche tenseur 100 un petit axe D_{100,y} de la couche tenseur 100 et un grand axe D_{100,x} de la couche tenseur 100. Les petits et grands axes peuvent également être désignés petits et grands diamètres.

Une deuxième étape du procédé selon l'invention illustrée aux figures 2H à 2J consiste en un retrait partiel de la couche sacrificielle 300 sélectivement à la couche d'intérêt 200 et à la couche tenseur 100. Plus exactement, lors de cette étape, on retire une portion de retrait 350 de la couche sacrificielle 300 tout en laissant en place une portion restante 360 de cette même couche 300. Les figures 2H à 2J illustre le retrait progressif de la portion de retrait 250. L'empilement obtenu après le retrait complet de la portion de retrait 250 est illustré à la figure 2J.

La portion de retrait 350 et la portion restante 360 sont décrites plus en détails ci-dessous.

La portion de retrait 350 s'étend entièrement au droit d'une portion latérale 250 de la couche d'intérêt 200 selon la direction verticale Z. La portion latérale 250 de la couche d'intérêt 200 s'étend depuis l'intégralité du flanc 203 de la couche d'intérêt. Ainsi, en projection dans le plan horizontal XY, lorsqu'à la fois le flanc 203 de la couche d'intérêt 200 et le flanc 363 de la portion restante 363 sont circulaires, et lorsque la portion restante 360 de la couche sacrificielle est centrée par rapport à la couche d'intérêt 200, la portion latérale 250 présente la forme d'une couronne circulaire. C'est cet exemple qui est illustré aux figures 2H à 2J.

La portion de retrait 350 définit par ailleurs, au niveau de son flanc interne 354, un contour fermé en projection dans le plan horizontal XY. Ce contour fermé correspond notamment à la projection dans le plan horizontal XY du flanc 363 de la portion restante 360. En effet le flanc interne 354 de la portion de retrait 350 et le flanc 363 de la portion restante 360 sont confondus. Avantageusement, ce contour fermé est de forme circulaire. Lorsque cela est le cas, on définit un diamètre de la portion restante 360 noté D₃₆₀.

La portion restante 360 de la couche sacrificielle 300 se trouve elle au droit d'une portion dite centrale 260 de la couche d'intérêt 200.

On définit également une portion latérale 150 et une portion centrale 160 de la couche tenseur 100, se trouvant respectivement au droit de la portion latérale 250 de la couche d'intérêt 200 et au droit de la portion centrale 260 de la couche d'intérêt 200.

La portion restante 360 de la couche sacrificielle forme dans cet exemple un plot 360.

Selon un mode de réalisation avantageux de l'invention, à la fois la couche d'intérêt 200, la couche tenseur 100 et le plot 360 présentent une forme circulaire en projection dans le plan horizontal XY et sont concentriques dans ce même plan. L'ensemble constitué du plot 360, de la couche d'intérêt 200 et de la couche tenseur admet alors une symétrie de révolution autour d'un axe 1000 parallèle à la direction verticale Z.

Le retrait de la portion de retrait 350 ainsi que ses effets sur l'empilement 1 vont maintenant être décrits.

Le retrait de la portion de retrait 350 est réalisé par gravure, typiquement une gravure à l'acide fluorhydrique (HF) en phase vapeur.

Ce retrait permet une libération mécanique partielle de la couche d'intérêt 200 et de la couche tenseur 100. Cette libération est notamment effective au niveau de la portion latérale 250 de la couche d'intérêt 200 et de la portion latérale 150 de la couche tenseur 100. En effet, lors de l'étape de fourniture de l'empilement 1, et de façon générale avant l'étape de retrait, la couche d'intérêt 200 et la couche tenseur 100 reposent entièrement sur la couche sacrificielle 300 et sont donc maintenues par celle-ci. Une fois la portion de retrait 350 retirée, la couche d'intérêt 200 et la couche tenseur 100 se retrouvent en suspens sur le plot 360. Elles reposent sur le plot 360 au niveau de la portion centrale 260 de la couche d'intérêt 200 et, indirectement, au niveau de la portion centrale 360 de la couche tenseur 100. Le plot 360 est ainsi le seul élément reliant le substrat support 400 et la couche d'intérêt 200.

La couche tenseur 100 et la couche d'intérêt 200 présentent chacune, avant l'étape de libération mécanique, une contrainte résiduelle notée respectivement σ₁₀₀ et σ₂₀₀. Ces contraintes résiduelles σ₁₀₀ et σ₂₀₀ sont générées par les conditions de dépôt des couches qu'elles caractérisent. Elles peuvent être soit en traction, soit en compression. Dans le cas particulier d'un substrat SOI (« Silicon On Insulator », en français « silicium sur isolant ») dont la couche supérieure de silicium peut jouer le rôle de couche d'intérêt, la fabrication du substrat engendre généralement une contrainte résiduelle en traction dans le silicium, typiquement de quelques MPa à quelques GPa.

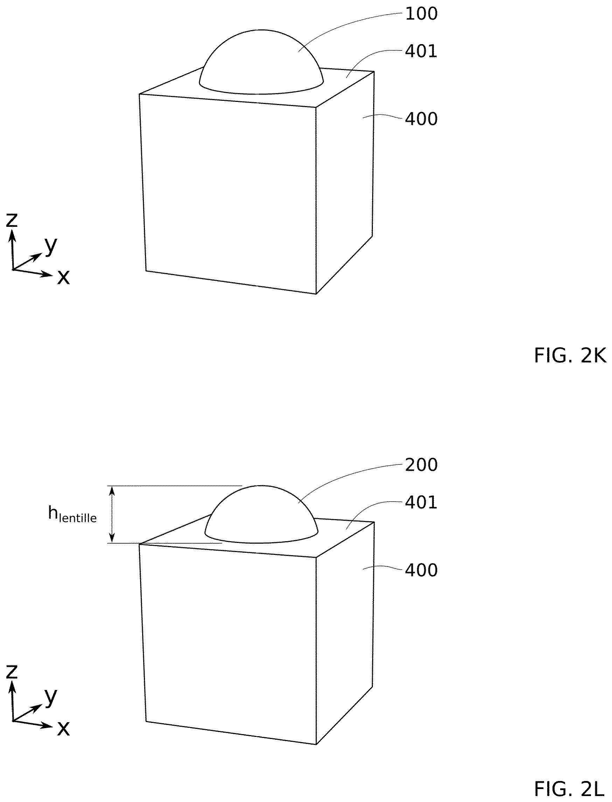

Du fait du retrait de la portion de retrait 350, les contraintes résiduelles σ₁₀₀ et σ₂₀₀ provoquent des déformations de la couche d'intérêt 200 et de la couche tenseur 100, notamment au niveau de leurs portions latérales 250, 150. En ce sens, la figure 2J illustre une étape théorique dans laquelle la portion de retrait 350 serait retirée et les couches d'intérêt 200 et tenseur 100 présenteraient la même forme qu'avant ce retrait. Un tel empilement est en réalité instable : la déformation de la couche d'intérêt 200 et de la couche tenseur 100 a en réalité lieu dès le retrait effectué et même durant le retrait. La figure 2K illustre l'empilement présentant cette déformation.

La contrainte résiduelle σ₂₀₀ de la couche d'intérêt 200 est généralement fixée par les différentes étapes qu'elle subit en amont du procédé selon l'invention. Ainsi, c'est la contrainte résiduelle σ₁₀₀ de la couche tenseur 100 qui est configurée pour permettre la déformation souhaitée de la couche d'intérêt 200. Le signe de la somme de la contrainte résiduelle σ₁₀₀ de la couche tenseur 100 et de la contrainte résiduelle σ₂₀₀ de la couche d'intérêt indique le sens de la déformation de la couche d'intérêt 200 provoquée par la couche tenseur 100 (rapprochement ou éloignement de la couche d'intérêt 200 par rapport au substrat support 400). L'amplitude de déformation de la couche d'intérêt 200 est également déterminée par la configuration de la contrainte résiduelle σ₁₀₀ de la couche tenseur 100.

La contrainte résiduelle σ₁₀₀ de la couche tenseur 100 est choisie en fonction de la flexion souhaitée en prenant en compte différents paramètres et notamment la contrainte résiduelle σ₂₀₀ de la couche d'intérêt 200 et l'épaisseur e₂₀₀ selon la direction verticale Z de la couche d'intérêt 200.

L'épaisseur e₁₀₀ selon la direction verticale Z de la couche tenseur 100 est par ailleurs un paramètre ayant un impact direct sur la contrainte résiduelle σ₁₀₀. Plus l'épaisseur e₁₀₀ est élevée, plus la contrainte résiduelle σ₁₀₀ diminue. Lorsque la couche tenseur 100 est à base de TiN, l'épaisseur e₁₀₀ est typiquement comprise entre quelques nanomètres, par exemple 2 nanomètres, et environ 100 nanomètres. L'épaisseur e₁₀₀ est de manière générale choisie en fonction des matériaux utilisés de sorte à obtenir le niveau de contrainte souhaité dans la couche tenseur 100.

Les différents paramètres, dont notamment l'épaisseur e₁₀₀ de la couche tenseur 100 et sa contrainte résiduelle σ₁₀₀, peuvent être choisis de façon à provoquer la traction ou la compression de la couche d'intérêt 200, et ainsi provoquer un éloignement ou un rapprochement de cette dernière par rapport au substrat support 400. Le procédé selon l'invention peut ainsi permettre de déformer la couche d'intérêt 200 selon les deux sens de la direction verticale Z. Le nitrure de titane (TiN) et le nitrure de silicium (SiN) et de façon plus générale les nitrures présentent l'avantage de pouvoir être en traction ou en compression selon leurs conditions de dépôt. Ils constituent donc des matériaux très intéressants pour la confection de la couche tenseur 100. Le TiN est notamment compressif sur des gammes d'une centaine de MPa à quelques GPa et pour une épaisseur de quelques nanomètres à une centaine de nanomètres.

En utilisant des conditions de dépôt spécifiques et en dimensionnant correctement les différentes couches, il est donc possible d'induire la déformation souhaitée (sens et amplitude) de la couche d'intérêt 200. L'homme du métier est parfaitement en mesure d'adapter ces paramètres pour obtenir la déformation souhaitée.

De façon avantageuse, le procédé permet de provoquer, lors du retrait de la portion de retrait 350, la déformation de l'ensemble de la couche d'intérêt 200 selon un unique sens de flexion. Tout particulièrement, la contrainte résiduelle σ₁₀₀ de la couche tenseur 100 et éventuellement son épaisseur e₁₀₀ est configurée/sont configurées pour que l'ensemble de la couche d'intérêt 200 suive un même mouvement : soit un rapprochement par rapport au substrat support 400, soit un éloignement par rapport au substrat support 400. Ces deux alternatives peuvent être désignées « flexion vers le bas » et « flexion vers le haut ». Ainsi, une fois le retrait effectué, la couche d'intérêt 200 présente une forme homogène, de préférence présentant une symétrie de révolution autour d'un axe parallèle à la direction verticale Z. Par exemple, dans le cas d'une couche d'intérêt 200 circulaire, une fois la portion de retrait 350 retirée, la couche d'intérêt 200 présente une forme se rapprochant d'une calotte sphérique, c'est-à-dire une portion de sphère délimitée par un plan. Il est entendu que de légères déviations par rapport à une forme parfaite peuvent exister, en fonction des aléas de fabrication et/ou de l'homogénéité structurelle des différentes couches, et notamment de la couche d'intérêt. Ces déviations peuvent également correspondre à la nanostructuration de la couche d'intérêt 200 décrite plus avant.

Il est à noter que les contraintes résiduelles σ₁₀₀, σ₂₀₀ peuvent être adaptées, au moins localement, afin d'atténuer ou d'exacerber la flexion provoquée par l'étape de retrait. Pour ce faire, il est possible de mettre en œuvre un recuit thermique ou une implantation ionique dans ces couches avant l'étape de retrait. Le recuit thermique peut éventuellement avoir lieu pendant l'étape de retrait, et l'implantation ionique peut également être mise en œuvre après l'étape de retrait.

Un recuit thermique engendre une relaxation des contraintes mécaniques de la couche. La contrainte résiduelle dépendra principalement de la différence de coefficient de dilatation thermique entre le substrat et la couche recuite, ou entre la couche recuite et la couche sous-jacente. Il est donc par exemple possible, en relaxant les contraintes mécaniques avant ou pendant le procédé selon l'invention, de rendre une couche initialement en contrainte compressive, en contrainte en traction.

Une implantation ionique peut permettre de modifier les contraintes sur certaines zones localisées de la couche d'intérêt 200 et/ou la couche tenseur 100. Cela permet un contrôle très précis de la courbure lors de l'étape de retrait.

Ainsi, l'étape de retrait partiel de la couche sacrificielle 300, ou étape de libération, permet une flexion de la couche d'intérêt 200, cette flexion pouvant être parfaitement contrôlée, même localement.

La figure 2P est une vue en coupe de l'empilement figurant à la fois la couche d'intérêt 200 et la couche tenseur 100 avant (pointillés) et après (traits pleins) déformation. Cette figure montre comment peut être quantifiée la déformation de la couche d'intérêt 200.

Dans le cas avantageux où la couche d'intérêt 200 et le plot 360 présentent tous deux une forme circulaire en projection dans le plan horizontal XY et sont concentriques dans ce même plan, comme cela est le cas en figure 2P, la déformation peut être mesurée selon la direction verticale Z, entre :
a. un plan supérieur 1001 dans lequel est inclue la face inférieure 252 de la portion centrale 250 de la couche d'intérêt 200, et
b. un plan inférieur 1002, parallèle au plan supérieur 1001 et passant par l'arête inférieure 204 de la couche d'intérêt 200, constituant généralement la zone de la couche d'intérêt 200 ayant subi le déplacement vertical le plus important. L'arête inférieure 204 de la couche d'intérêt 200 est définie par l'intersection du flanc 203 de la couche d'intérêt 200 et de sa face inférieure 202.

La distance selon la direction verticale Z entre ces deux plans 1001, 1002 est nommée flèche de la couche d'intérêt 200 et est notée f₂₀₀.

Lorsque la couche d'intérêt 200 et le plot 360 sont en contact comme cela est illustré à la figure 2P, la face supérieure 361 du plot 360 est également inclue dans le plan supérieur 1001.

La face inférieure 202 de la couche d'intérêt 200 est également typiquement inclue dans le plan supérieur 1001 avant la déformation.

De façon générale, même lorsque l'empilement n'admet pas de symétrie de révolution (par exemple du fait des aléas de fabrication), la déformation de la couche d'intérêt 200 peut être caractérisée en tout point de l'arête 204 de la couche d'intérêt 200 par une flèche locale. On assimilera typiquement la flèche f₂₀₀ de la couche d'intérêt 200 à la déformation mesurée au point de l'arête 204 présentant la flèche locale la plus élevée.

De préférence, après le retrait de la portion de retrait 350, la flèche f₂₀₀ de la couche d'intérêt 200 est supérieure à 100 nm, de préférence supérieure à 200 nm voire supérieure à 500 nm.

Dans le cas où la couche d'intérêt 200 est déformée de façon à être rapprochée du substrat support 400, on peut chercher à ce qu'il y ait un contact au moins partiel entre la couche d'intérêt 200 et le substrat support 400, au niveau de la face supérieure 401 de ce dernier. Avantageusement, les différents paramètres du procédé sont configurés de sorte que ce contact induise un collage au moins partiel de la couche d'intérêt 200 et du substrat support 400. Selon un mode de réalisation particulier, le contact assure à lui seul le collage. Un tel collage est notamment possible lors que le substrat support 400 et la couche d'intérêt 200 sont à base du même matériau, par exemple le silicium. Lorsque la couche d'intérêt 200 est déformée jusqu'à son collage au substrat support 400, la hauteur hₗₑₙₜᵢₗₗₑ de la structure obtenue, typiquement une lentille, est égale à la somme de la hauteur h₃₆₀ du plot 360 et de l'épaisseur e₂₀₀ de la couche d'intérêt 200 (voir figures 2J et 2L). L'épaisseur e₂₀₀ de la couche d'intérêt 200 étant généralement faible relativement à la hauteur h₃₆₀ du plot 360, on fait dans ce cas l'approximation hₗₑₙₜᵢₗₗₑ ≈ h₃₆₀.

Comme illustré par le passage de la figure 2K à la figure 2L, on prévoit avantageusement le retrait de la couche tenseur 100 après l'étape de retrait partiel de la couche sacrificielle 300. Cela permet de mettre à jour la couche d'intérêt 200. Dans le cas d'une couche d'intérêt en Si et d'une couche tenseur en TiN, une gravure humide dite SC1 (bain de nettoyage NH₄OH/H₂O₂/H₂O, avec un ratio allant généralement de 1:2:2 à 1:1:5) permet un retrait total et sélectif du TiN vis-à-vis du Si.

Ce retrait est facilité lorsqu'un collage au moins partiel de la couche d'intérêt 200 avec la face supérieure 401 du substrat support 400 a eu lieu. En effet, grâce au collage, la couche d'intérêt 200 reste en place et conserve la forme que lui a conféré la couche tenseur 100. Lorsqu'elle n'est pas collée au substrat support 400, la couche d'intérêt 200 risque de subir une nouvelle déformation lors du retrait de la couche tenseur 100. Cette nouvelle déformation serait orientée dans le sens inverse au sens de la déformation ayant lieu lors de l'étape de retrait partiel de la couche sacrificielle 300. Ce mode de réalisation améliore ainsi encore la maîtrise de la forme finale conférée à la structure tridimensionnelle. Le collage de la couche d'intérêt au substrat support 400 peut prévenir cette deuxième déformation. Il est entendu cependant qu'en cas d'absence de collage entre la couche d'intérêt 200 et le substrat support 400 cette deuxième déformation peut également être anticipée et prise en compte pour obtenir la déformation finale souhaitée.

Bien que les figures 2A à 2L illustrent la mise en œuvre du procédé pour une unique structure tridimensionnelle, il est entendu que le procédé selon l'invention peut être mis en œuvre pour une pluralité de structures tridimensionnelles partageant un même substrat support 400. La figure 2M illustre le résultat qui serait alors obtenu. Les références 200a, 200b, 200c désignent les différentes couches d'intérêt de chacun des structures obtenues visibles depuis cette vue. Les étapes décrites en référence aux figures 2A à 2L peuvent être réalisées simultanément pour une pluralité voire l'ensemble des structures. Dans ce mode de réalisation, avant retrait de la portion de retrait associé à chaque couche d'intérêt 200a, 200b, 200c, ces dernières présentent une face disposée dans le même plan, ici un plan horizontal. Typiquement, les faces supérieures des couches d'intérêt 200a, 200b, 200c peuvent former des disques distincts et disposés dans un même plan.

Les paragraphes suivants visent à proposer plusieurs combinaisons de matériaux pouvant être utilisées pour chacune des couches de l'empilement 1. Naturellement, ces exemples ne sont pas limitatifs et le procédé décrit peut être mis en œuvre avec de nombreux autres matériaux.

### Exemple 1 :

a. Substrat support : Si ou verre
b. Couche sacrificielle : SiO₂
c. Couche d'intérêt : Si ou SiGe
d. Couche tenseur : TiN ou AIN

### Exemple 2:

a. Substrat support : Si ou verre
b. Couche sacrificielle : SiARC
c. Couche d'intérêt : Si ou SiGe
d. Couche tenseur : TiN ou AIN

### Exemple 3 :

a. Substrat support : Si ou verre
b. Couche sacrificielle : SiON
c. Couche d'intérêt : Si ou SiGe
d. Couche tenseur : TiN ou AIN

### Exemple 4 :

a. Substrat support : Si ou verre
b. Couche sacrificielle : SiN
c. Couche d'intérêt : Si, par exemple silicium amorphe
d. Couche tenseur : TiN ou AIN

### Exemple 5 :

a. Substrat support : Si ou verre
b. Couche sacrificielle : SiN
c. Couche d'intérêt : SiGe
d. Couche tenseur : TiN ou AIN

Le procédé selon l'invention peut faire l'objet de simulations numériques réalisées par la méthode des éléments finis (couramment désignée par l'acronyme anglais FEM, « Finite Element Method »). Ces simulations ont pour but de prévoir les différents paramètres dimensionnels et expérimentaux nécessaires à l'obtention d'une structure à la forme et aux dimensions souhaitées. Typiquement, on cherche à connaître les dimensions latérales du plot 360 - et donc le temps de gravure de la couche sacrificielle 300 - requises pour obtenir la flexion souhaitée, par exemple une flexion menant au collage de la couche d'intérêt 200 au substrat support 400.

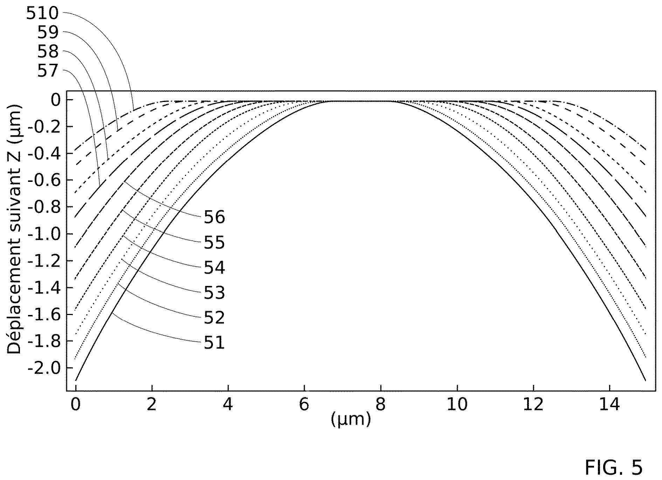

Les simulations dont les résultats sont présentés en figure 5 concernent le cas particulier et préféré de structures circulaires. On s'intéresse donc tout particulièrement au diamètre des couches d'intérêt et tenseur 100, 200 et au diamètre du plot 360. L'objectif est ici de déterminer le temps de gravure requis pour que le diamètre du plot 360 soit tel que la flexion de la couche d'intérêt 200 mène à un collage de cette dernière au substrat support 400, et ce en fonction de la hauteur du plot 360. Les autres paramètres (matériaux, épaisseurs de la couche d'intérêt 200 et de la couche tenseur 100...) sont fixés. Il est à noter que dans cet exemple non limitatif l'objectif étant d'obtenir le collage de la couche d'intérêt 200 au substrat support 400, la hauteur h₃₆₀ du plot 360 correspond à la hauteur hₗₑₙₜᵢₗₗₑ de la lentille obtenue en fin de procédé.

La structure incrémentée dans le logiciel comprend un substrat SOI comprenant un oxyde enterré (BOX) jouant le rôle de couche sacrificielle et une couche de silicium jouant le rôle de couche d'intérêt. L'oxyde enterré, à base de SiO₂, présente une épaisseur de 2 µm selon la direction verticale Z tandis que la couche de silicium présente une épaisseur de 50 nm. Une couche de nitrure de titane (TiN) joue le rôle de couche tenseur et présente une épaisseur de 30 nm.

En projection dans le plan horizontal XY, la couche d'intérêt et la couche tenseur présentent un diamètre de 15 µm. Ces couches reposent sur un plot de SiO₂ ayant une hauteur de 2 µm et un diamètre variant de 1 à 10 µm. Le ratio entre la hauteur et le diamètre de la lentille obtenue en fin de procédé est donc égal à 7,5.

Les différentes courbes du graphique représenté en figure 5 correspondent à la même simulation, menée pour différentes valeurs de diamètre D₃₆₀ du plot 360 de SiO₂ (courbe 51 : D₃₆₀=1µm, courbe 52 : D₃₆₀=2µm, courbe 53 : D₃₆₀=3µm, courbe 54 : D₃₆₀=4µm, courbe 55 : D₃₆₀=5µm, courbe 56 : D₃₆₀=6µm, courbe 57 : D₃₆₀=7µm, courbe 58 : D₃₆₀=8µm, courbe 59 : D₃₆₀=9µm, courbe 510 : D₃₆₀=10µm). Elles illustrent ainsi la déflexion de la couche d'intérêt 200 (couche de silicium) en fonction du diamètre du plot 360.

On observe notamment que ces résultats prédisent une flexion homogène de 2 µm pour un plot de SiO₂ présentant un diamètre de 2 µm. Or, la hauteur h₃₆₀ du plot de SiO₂ est de 2 µm (épaisseur du BOX). On a donc h₃₆₀=hₗₑₙₜᵢₗₗₑ pour d₃₆₀=2 µm. Cette simulation permet donc de prévoir qu'il faut donner au plot de SiO₂ un diamètre de 2 µm pour obtenir un collage de la couche d'intérêt 200 avec le substrat support 400. Les conditions de gravure de la couche sacrificielle (BOX du SOI) en découlent directement.

Le procédé selon l'invention présente donc l'avantage d'avoir des résultats pouvant être facilement anticipés. Sa mise en oeuvre s'en retrouve facilitée et les structures obtenues correspondent parfaitement au cahier des charges fixé.

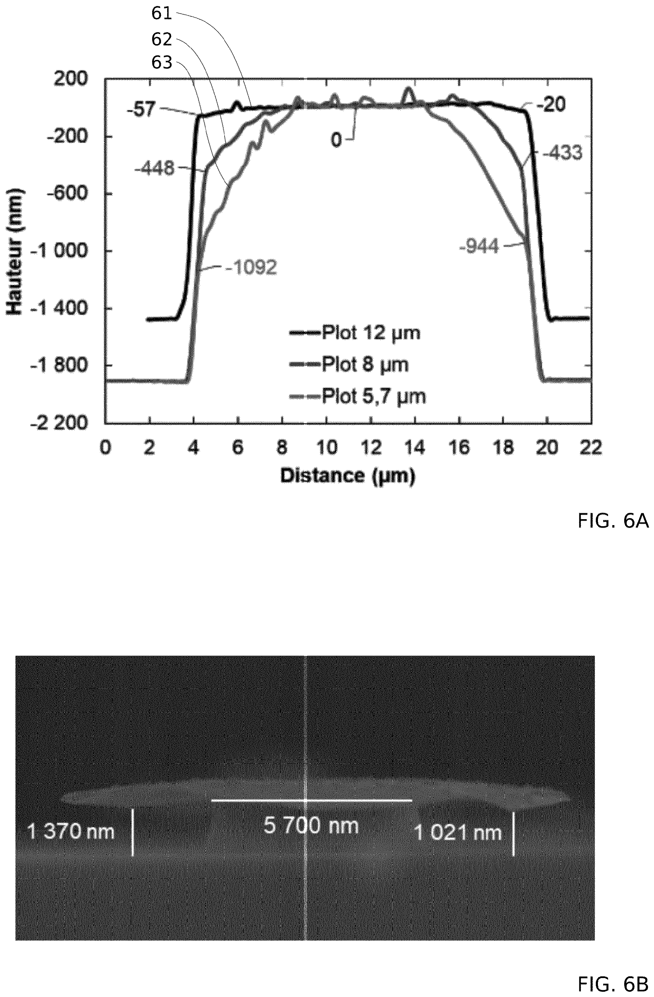

Des exemples expérimentaux vont maintenant être présentés en référence aux figures 6A à 7D.

Un premier exemple est réalisé avec l'empilement suivant :
a. Couche sacrificielle en SiO₂ présentant une épaisseur de 2 µm,
b. Couche d'intérêt en Si présentant une épaisseur de 20 nm, un diamètre de 15 µm et une contrainte résiduelle de +0,133 MPa,
c. Couche tenseur en TiN présentant une épaisseur de 30 nm, un diamètre de 15 µm et une contrainte résiduelle de -2,02 GPa.

Le masque de lithographie utilisé pour la microstructuration permet de réaliser des plots de 5, 10, 15 et 20 µm à partir de la couche sacrificielle. Une fois le transfert réalisé dans le TiN puis dans le silicium par gravure sèche, suivant le procédé décrit plus haut en référence aux figures 2C à 2G, une gravure en phase valeur au HF est réalisée en plusieurs étapes. La vitesse de gravure théorique utilisée est de 25 nm/min. Après chaque étape de gravure, les disques suspendus contraints sont mesurés à l'aide d'un microscope à force atomique (ou AFM, pour « Atomic Force Microscopy ») (figure 6A), puis des clichés réalisés par microscopie électronique à balayage (MEB) en section transversale sont réalisés après la dernière étape de gravure (figure 6B).

Une première étape de gravure mène à une première libération caractérisée par un plot résiduel de SiO₂ présentant un diamètre de 12 µm. Cette première libération entraîne une déflexion d'une quarantaine de nanomètres (courbe 61). Une deuxième étape de gravure permet une libération plus importante de la couche d'intérêt et de la couche tenseur. Elle se caractérise par un plot résiduel de SiO2 d'un diamètre de 8 µm. Elle produit une déflexion d'environ 440 nm (courbe 62). Enfin, une troisième et dernière gravure permettant d'obtenir un plot résiduel de SiO₂ d'un diamètre de 5,7 µm engendre une déflexion de 1 000 nm (courbe 63).

L'image MEB en coupe (figure 6B) confirme qu'à la fin du procédé, le plot 360 de SiO2 présente un diamètre de 5,7 µm.

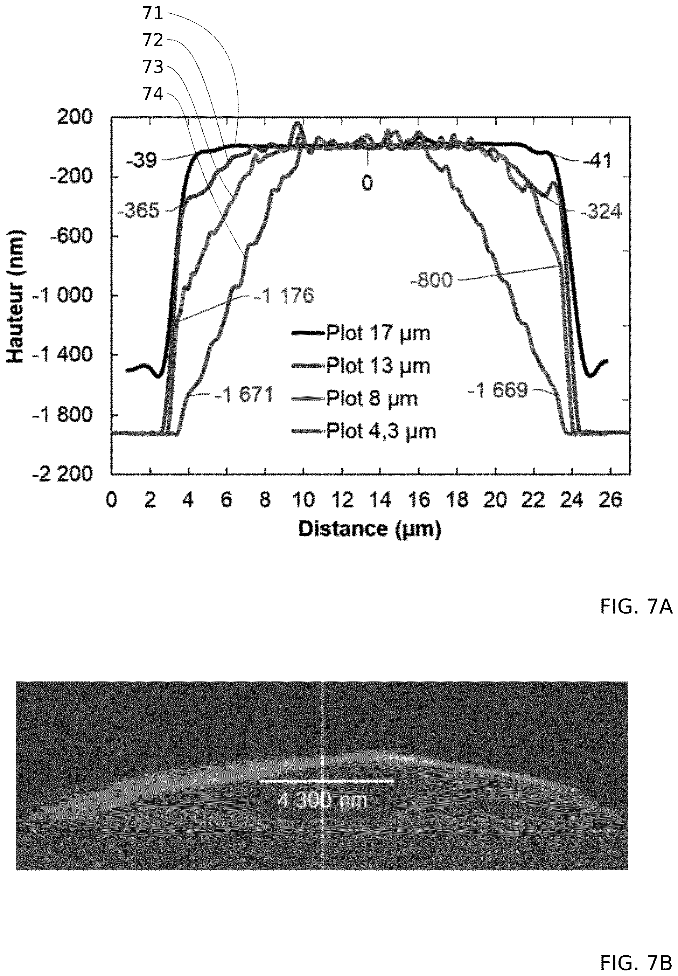

Une étude similaire est réalisée avec les mêmes paramètres expérimentaux à l'exception du diamètre de la couche d'intérêt et de la couche tenseur, fixé cette fois à 20 µm. Les résultats obtenus sont présentés à la figure 7A (analyse AFM) et aux figures 7B à 7D (clichés MEB).

Les trois premières étapes de gravure donnent des résultats très proches de ceux obtenus pour un disque de 15 µm. En effet, les libérations successives produisent dans un premier temps une déflexion moyenne d'une quarantaine de nanomètres (courbe 71), puis d'environ 350 nm (courbe 72) et enfin de maximum 1 176 nm (courbe 73). La quatrième et dernière libération par gravure donne lieu à des plots résiduels de 4,3 µm (courbe 74). Le profil AFM montre une déflexion d'environ 1 670 nm. Or, sur le cliché MEB reproduit à la figure 7B, le microdisque est en contact avec le substrat, ce qui signifie que des déflexions de 2 000 nm (hauteur du plot de SiO₂) sont atteintes par endroits. Ces résultats montrent que la formation de structures 3D d'une hauteur de 2 µm est réalisable par flexion contrôlée de microdisques. De plus, les microdisques fléchis sont résilients malgré les faibles épaisseurs des couches de silicium (couche d'intérêt) et de nitrure de titane (couche tenseur).

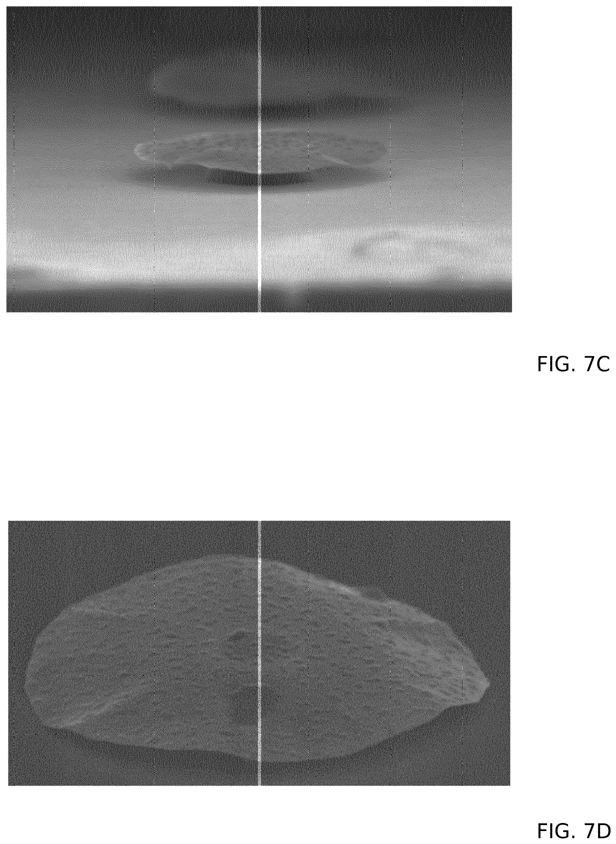

Les figures 7C et 7D sont des clichés MEB pris à partir d'angles de vue différents de celui de la figure 7B qui constituait une vue en coupe de la structure. Ces clichés mettent en évidence que certaines zones de la couche d'intérêt présentent une déflexion plus importante que d'autres. En effet, certaines zones des microdisques ont un fléchissement plus important. Dans le cas étudié ici, cette déformation inhomogène peut être causée par la couche d'intérêt, constituée de silicium. En effet, la cristallinité du silicium génère des propriétés physiques différentes selon les directions cristallines, entraînant par exemple des variations dans le module d'Young de 130 à 180 GPa. Ces différences de déflexion peuvent être sans conséquence sur les performances de la structure, et il est donc possible de les ignorer. Si au contraire au cherche à obtenir une déflexion homogène, on optera de préférence pour une couche d'intérêt 200 à base de matériaux amorphes. L'utilisation de ce type de matériaux permet de s'affranchir des variations des propriétés physiques intrinsèques liées aux directions cristallines. La déformation s'en retrouve donc homogène sur toute la structure.

Les résultats expérimentaux pour les microdisques de 15 µm ont été superposés aux résultats des simulations menées par la méthode des éléments finis.

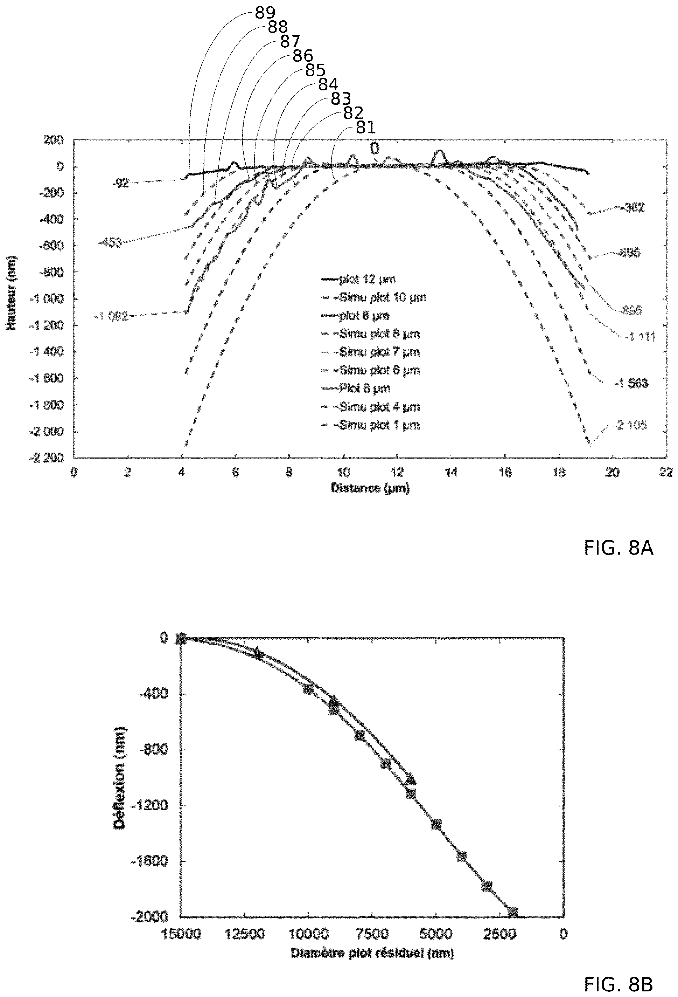

La figure 8A représente en traits pleins les résultats expérimentaux et en pointillés ceux des simulations numériques, et ce pour différents diamètres de plots résiduels (courbe 81 : 1 µm, courbe 82 : 4 µm, courbes 83 et 84 : 6 µm, courbe 85 : 7 µm, courbes 86 et 87 : 8 µm, courbe 88 : 10 µm, courbe 89 : 12 µm). Pour des plots résiduels de 6 et 8 µm, les courbes de déflexions obtenues par simulation se superposent parfaitement avec celles expérimentales. Ainsi, pour un plot de 6 µm, la déflexion expérimentale maximale est de 1092 nm contre 1111 nm dans la simulation.

La figure 8B représente la déflexion maximale obtenue en fonction du diamètre du plot résiduel pour les résultats des simulations (courbe à points carrés) et expérimentaux (courbe à points triangulaires). En plus de la proximité des résultats entre les deux, il est à noter que les déflexions maximales obtenues par simulation forment une courbe en forme de S en fonction du diamètre du plot. Cette forme concorde avec les premiers résultats expérimentaux.

Les résultats obtenus concordent avec les simulations de fabrication de microstructures 3D par flexion contrôlée de microstructures. Cela montre que le procédé décrit ci-dessus permet d'obtenir des structures tridimensionnelles dont les formes sont parfaitement prévisibles. En outre, l'homme du métier peut aisément établir un abaque de microstructures 3D réalisables par flexion contrôlée.

Selon un mode de réalisation avantageux de l'invention, le procédé comprend une étape de structuration de la couche d'intérêt 200 ou d'une couche d'intérêt secondaire 200'.

Cette structuration peut par exemple être qualifiée de nanostructuration. Les motifs réalisés par cette structuration présentent des dimensions supérieures à celles de la couche d'intérêt 200. Typiquement la nanostructuration forme des motifs présentant des dimensions critiques inférieures au micromètre et de préférence inférieure à 500 nanomètres, voire inférieures à 100 nanomètres, voire inférieures à 20 nanomètres.

Une telle nanostructuration peut conférer des propriétés très avantageuses à la structure formée. Dans le cas de microlentilles, la nanostructuration peut par exemple leur conférer des propriétés anti-reflet.

Cette application s'inspire des yeux de papillons de nuit dont la surface peut être assimilée à un réseau de microlentilles présentant chacune une structuration nanométrique anti-reflet. D'un côté, le réseau de microlentilles permet de focaliser la lumière sur des photorécepteurs, améliorant ainsi le champ de vision de l'insecte. Ce réseau de microlentilles est obtenu par déformation par flexion de la couche d'intérêt selon le procédé décrit ci-dessus. De l'autre, le réseau nanométrique augmente la quantité de lumière captée par l'oeil via la réduction des reflets lumineux, quel que soit l'angle incident de la lumière. Ce réseau nanométrique est obtenu par texturation de la couche d'intérêt. Par ailleurs, la combinaison de ces deux structures - micrométrique et nanométrique - donne d'autres fonctionnalités aux yeux des papillons de nuit, comme par exemple une super-hydrophobicité et un effet antibuée.

Cette structuration multiple est couramment appelée structure hiérarchique ou multi-échelle. La réalisation de telles structures fait aujourd'hui face à des contraintes d'intégration fortes, l'ajout d'une structure nanométrique sur une forme micrométrique non-planaire n'étant pas anodine.

Le procédé selon ce mode de réalisation constitue une solution passant tout d'abord par une structuration nanométrique, puis une microstructuration. Grâce à cette chronologie, la nanostructuration est facilitée puisqu'elle est réalisée sur une surface plane, avant la flexion de la couche d'intérêt. Ceci présente l'avantage d'offrir une flexibilité vis-à-vis des nanostructures imaginables et des méthodes de nanostructuration pouvant être mises en œuvre. Il est notamment possible d'utiliser des techniques de nanostructuration aussi variées que la lithographie optique, l'autoassemblage de copolymères à blocs ou encore la nanoimpression. La technique employée, par exemple le type de lithographie optique, pourra être choisie en fonction de la résolution désirée pour la nanostructuration.

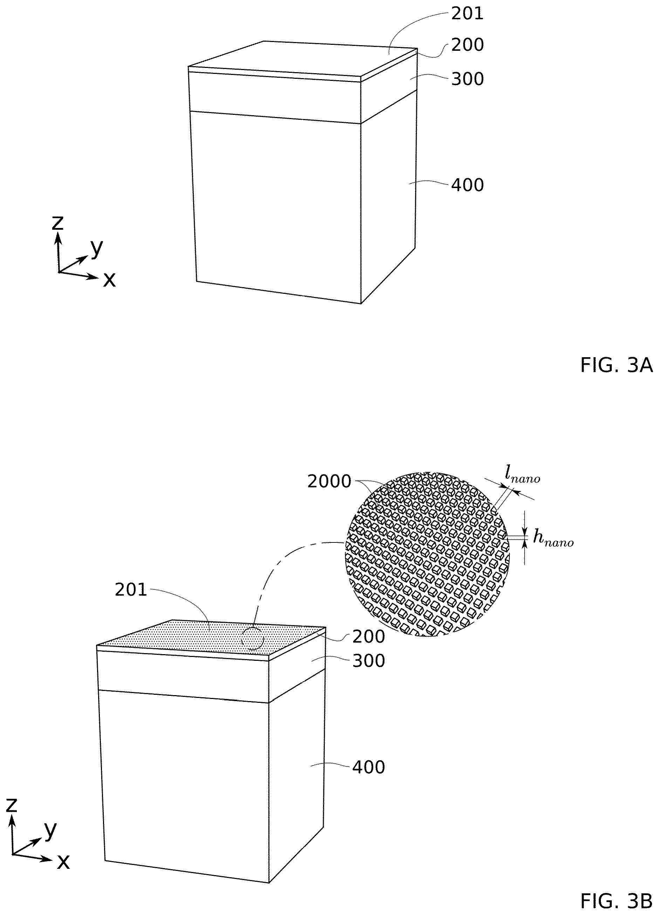

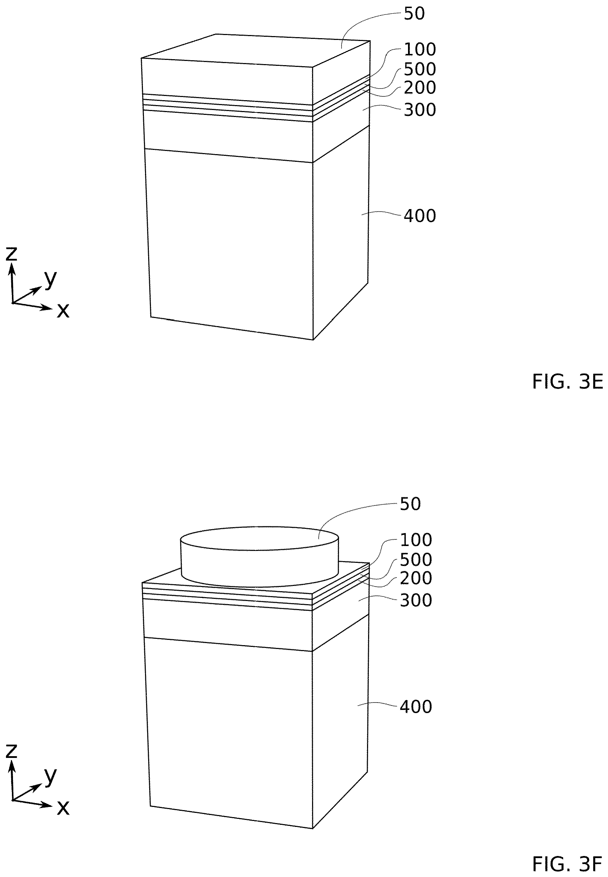

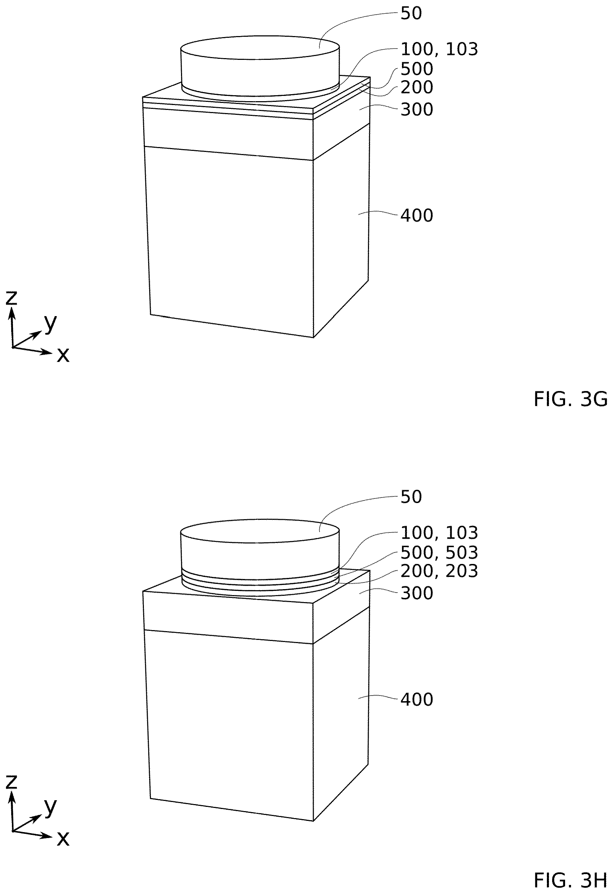

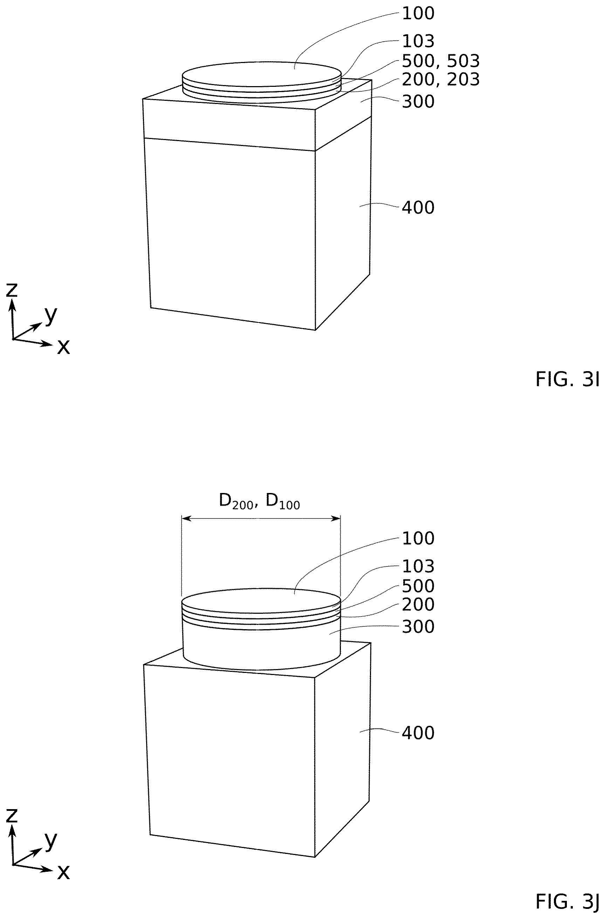

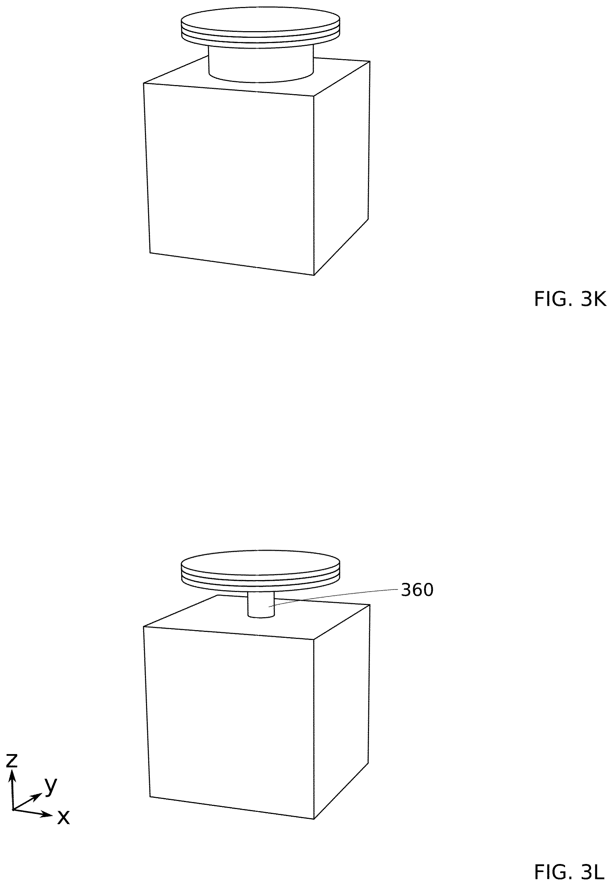

Un premier exemple du mode de réalisation avec nanostructuration est illustré aux figures 3A à 3O.

La figure 3A, comme la figure 2A, illustre la fourniture d'un empilement initial comprenant le substrat support 400, la couche sacrificielle 300 et la couche d'intérêt 200. La figure 3B illustre la nanostructuration de la couche d'intérêt 200 à partir de sa face supérieure 201. Cette étape de nanostructuration de la surface supérieure 201 permet de former dans la couche d'intérêt 200 des nanostructures 2000 ayant une hauteur hₙₐₙₒ selon la direction verticale Z et une dimension caractéristique Iₙₐₙₒ dans le plan horizontal XY. Si les nanostructures 2000 ont une forme de carré en projection dans le plan XY, Iₙₐₙₒ correspondra par exemple au côté de ce carré. Typiquement Iₙₐₙₒ < 100 nanomètres.

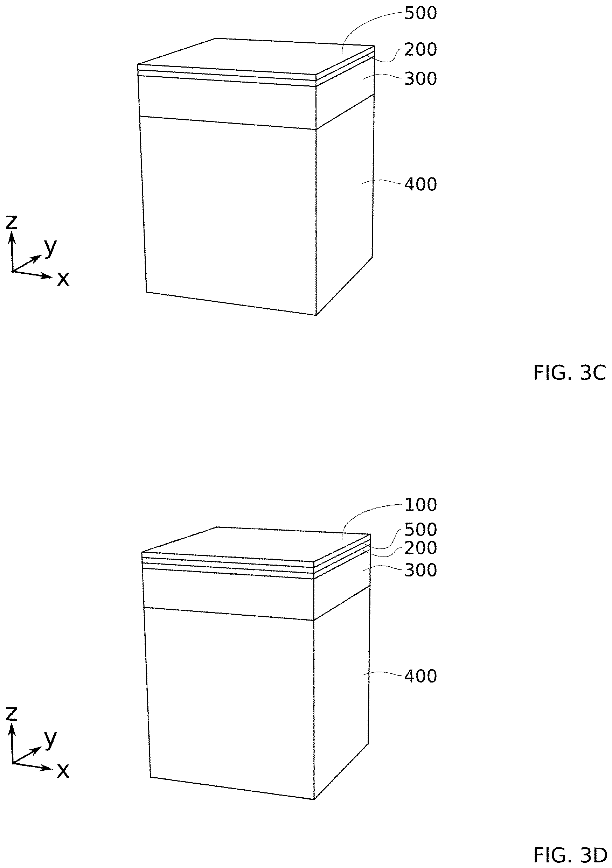

Une couche de planarisation 500 est ensuite déposée sur la couche d'intérêt 200 (figure 3C) afin de permettre que le dépôt de la couche tenseur (figure 3D) se fasse sur une surface plane.

Les étapes illustrées par les figures 3E à 3L sont similaires aux étapes décrites précédemment en référence aux figures 2C à 2J. L'unique différence réside en ce que la gravure de l'empilement 1 au travers de la couche de masquage 50 comprend également la gravure de la couche de planarisation 500. Lors de ces étapes, la couche d'intérêt 200 est microstructurée, de préférence de sorte à lui donner une forme circulaire dans le plan horizontal XY. Elle présente alors un diamètre D₂₀₀ dans le plan horizontal XY. On a typiquement un rapport de forme compris entre 40 et 1000 entre Iₙₐₙₒ et D₂₀₀. Selon un exemple, les motifs réalisés par la nano structuration sont répartis sur toute la surface de la couche intérêt 200. Alternativement, ils peuvent être répartis sur une zone seulement de la couche intérêt 200 tout en laissant libre une autre zone de la couche intérêt 200. Selon un exemple, ces motifs sont répartis de manière périodique. Ils peuvent également être répartis de manière non périodique. Cela permet par exemple d'associer les motifs de la nanostructuration à certains angles d'incidence seulement de rayons lumineux parvenant à la lentille recouverte de ces nanostructurations.

Suite au retrait de la portion de retrait 350 de la couche sacrificielle, la couche d'intérêt et la couche de planarisation 50 subissent une flexion du fait des contraintes résiduelles résidant dans la couche tenseur 100 (passage de la figure 3L à la figure 3M).

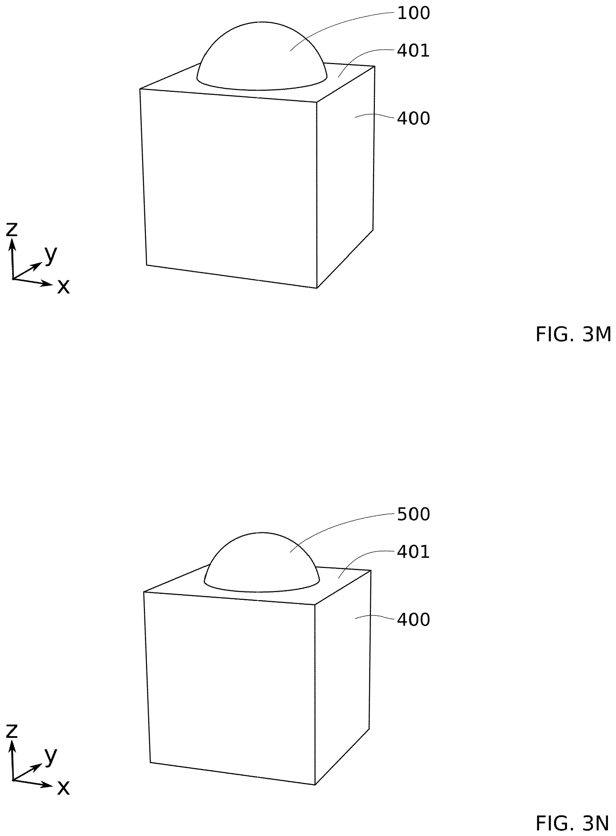

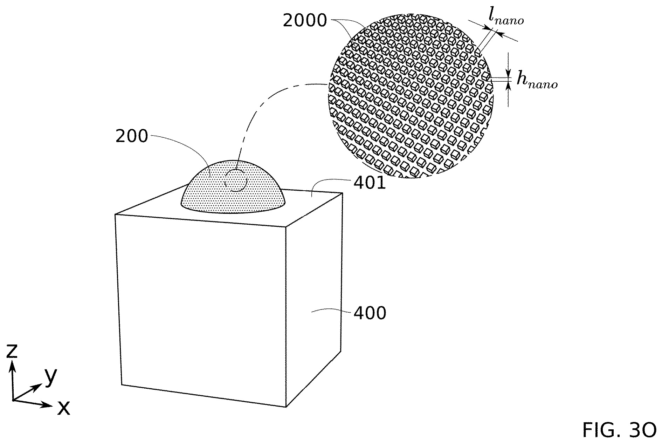

De préférence, on procède au retrait de la couche tenseur 100 (figure 3M) puis au retrait de la couche de planarisation 500 (figure 3N) afin de mettre à jour la couche d'intérêt 200 présentant la nanostructuration réalisée préalablement (figure 3O).

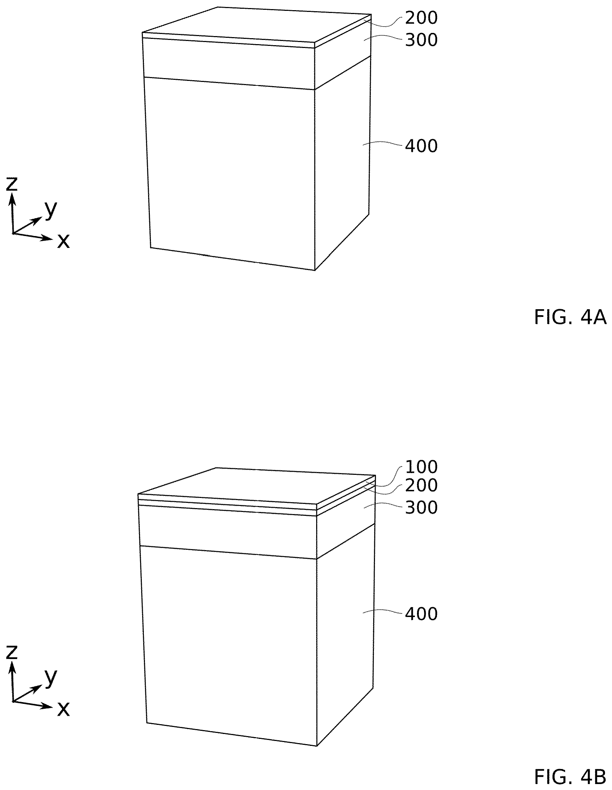

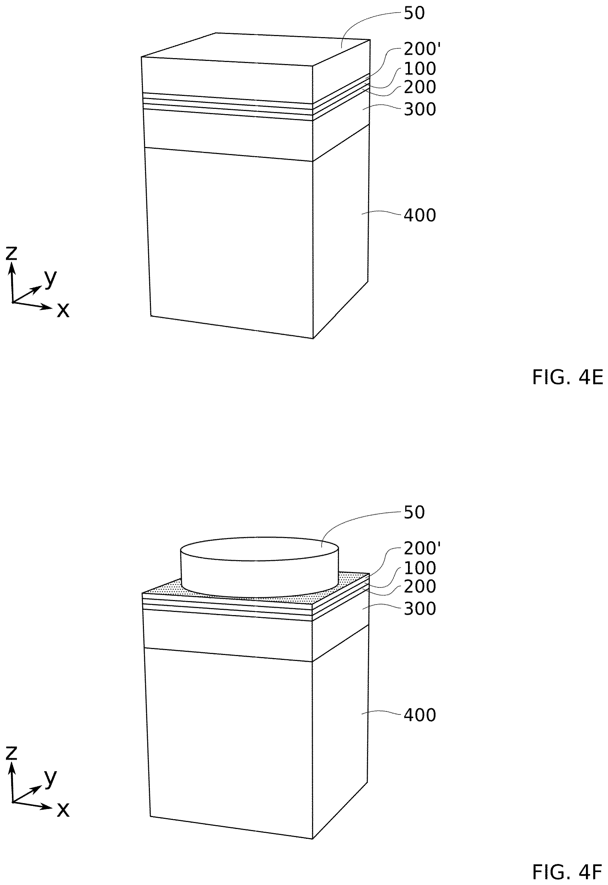

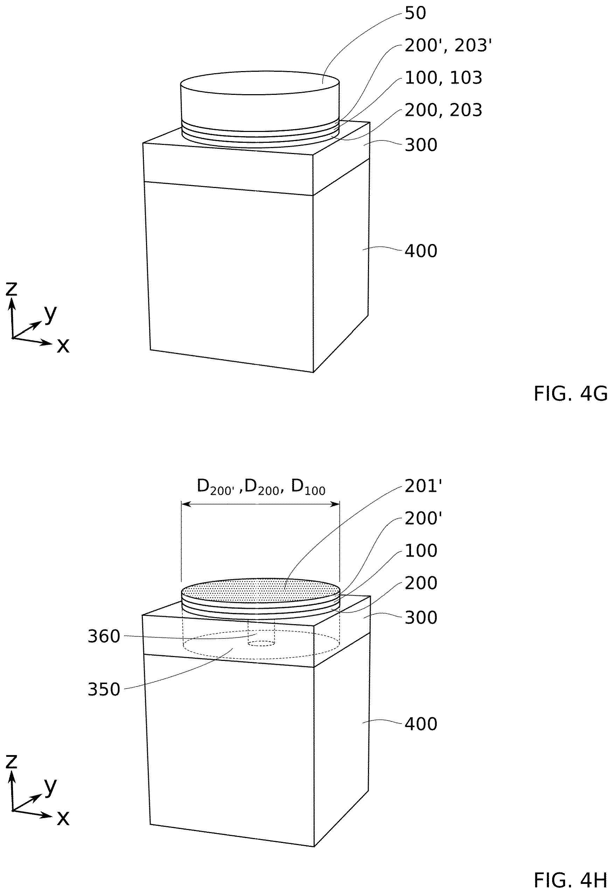

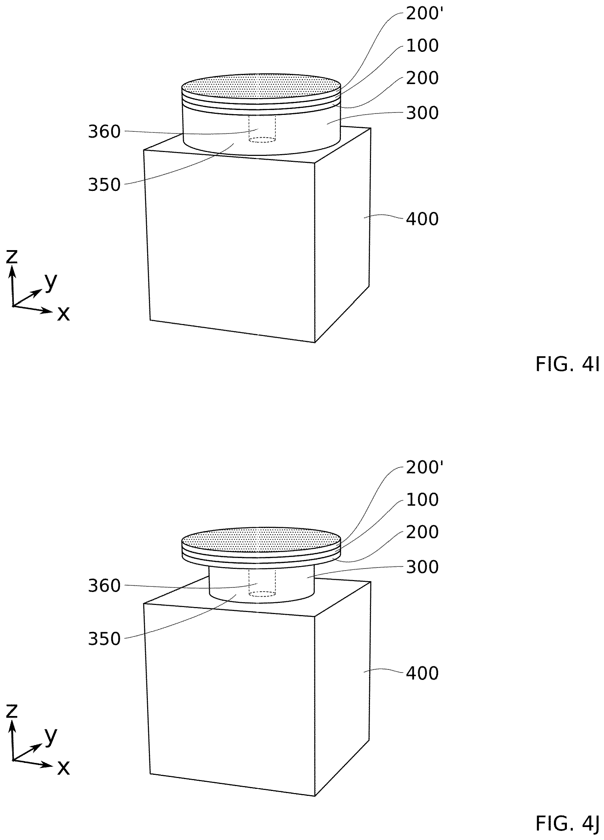

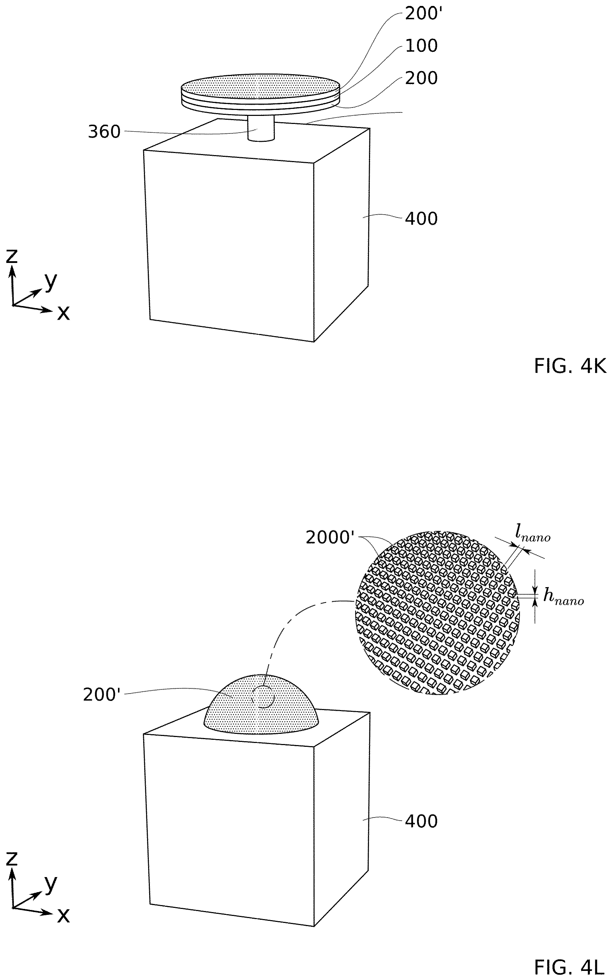

Un deuxième exemple du mode de réalisation avec nanostructuration est illustré aux figures 4A à 4L.

La figure 4A, comme la figure 2A et la figure 3A, illustre la fourniture d'un empilement initial comprenant le substrat support 400, la couche sacrificielle 300 et la couche d'intérêt 200. Comme illustré à la figure 4B, la couche tenseur 100 est ensuite déposée sur la couche d'intérêt 200.

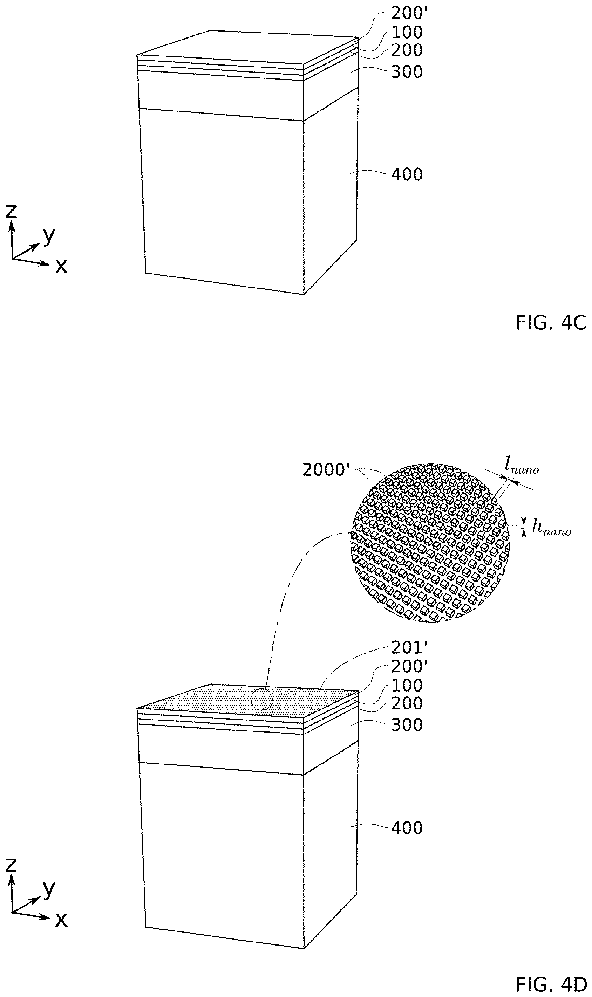

Une couche d'intérêt secondaire 200' est ensuite déposée sur la couche tenseur 100 (figure 4C). C'est cette fois la surface supérieure 201' de la couche d'intérêt secondaire 200' qui est nanostructurée (figure 4D), de sorte à former des nanostructures 2000'. Les caractéristiques décrites dans le cadre de l'exemple précédente au sujet de la nanostructuration de la couche d'intérêt 200 s'appliquent mutatis mutandis à la nanostructuration de la couche d'intérêt secondaire 200'.

Les étapes illustrées par les figures 4E à 4K sont similaires aux étapes décrites précédemment en référence aux figures 2C à 2J. L'unique différence réside en ce que la gravure de l'empilement 1 au travers de la couche de masquage 50 comprend également la gravure de la couche d'intérêt secondaire. Lors de ces étapes, la couche d'intérêt secondaire 200' est microstructurée, de préférence de sorte à lui donner une forme circulaire dans le plan horizontal XY. Elle présente alors un diamètre D_{200'} dans le plan horizontal XY. On a typiquement un rapport de forme compris entre 40 et 1 000 entre Iₙₐₙₒ et D_{200'}.

Suite au retrait de la portion de retrait 350 de la couche sacrificielle, la couche d'intérêt 200 et la couche d'intérêt secondaire 200' subissent une flexion du fait des contraintes résiduelles résidant dans la couche tenseur 100 (passage de la figure 4K à la figure 4L).

Dans cet exemple, la surface nanostructurée (surface supérieure 201' de la couche d'intérêt secondaire 200') se trouve au-dessus selon la direction verticale de la couche tenseur 100. Afin de pouvoir utiliser cette surface pour diverses applications, on ne procède donc pas au retrait de la couche tenseur.

La structure 3D nanostructurée ainsi obtenue trouve comme application particulièrement avantageuse la nanoimpression. Elle peut en effet servir de moule maître (couramment désigné par l'anglicisme « moule master ») dans un tel procédé.

A travers les différents modes de réalisation décrits ci-dessous, il apparaît clairement que l'invention propose une solution performante et simple à mettre en œuvre pour fabriquer des structures 3D, tout particulièrement des microlentilles, présentant éventuellement un niveau nanométrique de structuration.

Il est entendu que le principe de double structuration appliqué au procédé selon l'invention peut être mis en œuvre à une échelle supérieure. On peut par exemple réaliser une première structuration pour former un dispositif global (typiquement une lentille) de plusieurs centaines de micromètres par la technique de flexion contrôlée décrite précédemment. Un réseau de microlentilles à la surface de la lentille peut être réalisé en amont, par une deuxième structuration, selon les mêmes procédés que ceux décrits précédemment pour l'obtention d'une nanostructuration à la surface d'une microlentille. Dans ce cas, les dimensions caractéristiques de la deuxième structuration correspondent à celles d'une microstructuration telle que présentée plus haut.

## Revendications

1. Procédé de fabrication d'une structure tridimensionnelle comprenant les étapes suivantes :
• une fourniture d'un empilement (1) comprenant, empilés selon une direction dite verticale (Z), au moins :
i. un substrat support (400),
ii. une couche sacrificielle (300),
iii. une couche d'intérêt (200) délimitée dans toutes les directions d'un plan perpendiculaire à la direction verticale (Z), dit plan horizontal (XY), par un flanc (203),
iv. une couche tenseur (100) délimitée dans toutes les directions du plan horizontal (XY) par un flanc (103), la couche tenseur (100) présentant une contrainte résiduelle σ₁₀₀,
• un retrait d'une portion de la couche sacrificielle, dite portion de retrait (350), sélectivement à la couche d'intérêt (200) et à la couche tenseur (100), la portion de retrait (350) formant un contour fermé en projection dans le plan horizontal, la portion de retrait (350) étant entièrement située au droit d'une portion latérale (250) de la couche d'intérêt (200) s'étendant depuis l'intégralité du flanc (203) de la couche d'intérêt (200), le retrait de la portion de retrait (350) étant effectué de sorte à conserver une portion de la couche sacrificielle (300), dite portion restante (360), située au droit de la couche d'intérêt (200) et de la couche sacrificielle (300),
la contrainte résiduelle σ₁₀₀ de la couche tenseur (100) étant configurée pour provoquer une flexion de l'ensemble de la couche d'intérêt (200) selon un unique sens de flexion lors de l'étape de retrait de la portion de retrait (350).

2. Procédé selon la revendication précédente dans lequel le flanc (203) de la couche d'intérêt (200) et le flanc (103) de la couche tenseur (100) présentent chacun une forme sensiblement elliptique ou sensiblement circulaire en projection dans le plan horizontal (XY).

3. Procédé selon l'une quelconque des revendications précédentes dans lequel la portion restante (360) présente un flanc (363) présentant une forme sensiblement elliptique ou sensiblement circulaire en projection dans le plan horizontal (XY).

4. Procédé selon la revendication précédente en combinaison avec la revendication 2 dans lequel le flanc (203) de la couche d'intérêt (200), le flanc (103) de la couche tenseur (100) et le flanc (363) de la portion restante (360) présentent chacun une forme sensiblement circulaire en projection dans le plan horizontal (XY), dans lequel la couche d'intérêt (200) présente un diamètre D₂₀₀ dans le plan horizontal (XY) et la portion restante (360) présente un diamètre D₃₆₀ dans le plan horizontal (XY), et dans lequel, après le retrait de la portion de retrait (350), la couche d'intérêt (200) présente une flèche f₂₀₀, avec f₂₀₀≥0,05*(D₂₀₀-D₃₆₀), de préférence f₂₀₀≥0,10*(D₂₀₀-D₃₆₀).

5. Procédé selon l'une quelconque des deux revendications précédentes dans lequel la couche d'intérêt (200) présente un diamètre D₂₀₀ dans le plan horizontal (XY) et la portion restante (360) présente un diamètre D₃₆₀ dans le plan horizontal (XY), et dans lequel, après le retrait de la portion de retrait (350), le rapport D₂₀₀/D₃₆₀ est supérieur à 2, de préférence supérieur à 3.

6. Procédé selon les revendications 2 et 3 en combinaison dans lequel le flanc (203) de la couche d'intérêt (200), le flanc (103) de la couche tenseur (100) et le flanc (363) de la portion restante (360) présentent chacun une forme sensiblement elliptique en projection dans le plan horizontal (XY), dans lequel la couche d'intérêt (200) présente un petit axe D_{200,y} dans le plan horizontal (XY) et la portion restante (360) présente un petit axe D_{360,y} dans le plan horizontal (XY), et dans lequel, après le retrait de la portion de retrait (350), la couche d'intérêt (200) présente, en coupe selon un plan perpendiculaire au plan horizontal (XY) et contenant le petit axe de la couche d'intérêt 200, une flèche f₂₀₀, avec f₂₀₀≥0,05*(D_{200,y}-D_{360,y}), de préférence f₂₀₀≥0,10*(D_{200,y}-D_{360,y}).

7. Procédé selon l'une quelconque des revendications précédentes configuré de sorte que la flexion de la couche d'intérêt (200) rapproche son flanc (203) du substrat (400).

8. Procédé selon la revendication précédente configuré de sorte que la flexion de la couche d'intérêt (100) provoque le contact de la couche d'intérêt (200) avec le substrat support (400).

9. Procédé selon la revendication précédente comprenant le collage d'une partie au moins de la couche d'intérêt (200) avec le substrat support (400).

10. Procédé selon l'une quelconque des revendications 1 à 6 dans lequel la flexion de la couche d'intérêt (200) éloigne son flanc (203) du substrat (400).

11. Procédé selon l'une quelconque des revendications précédentes dans lequel |σ₁₀₀| > 500 MPa et de préférence |σ₁₀₀| > 1 000 MPa.

12. Procédé selon l'une quelconque des revendications précédentes dans lequel, avant l'étape de retrait, la couche d'intérêt (200) présente une contrainte résiduelle σ₂₀₀ avec |σ₂₀₀| ≤100 MPa.

13. Procédé selon l'une quelconque des revendications précédentes dans lequel la couche d'intérêt (200), après l'étape de retrait de la portion de retrait (350) de la couche sacrificielle (300), forme une lentille.

14. Procédé selon l'une quelconque des revendications précédentes comprenant, préalablement à l'étape de retrait de la portion de retrait (350) de la couche sacrificielle (300), une étape de structuration de l'au moins une couche d'intérêt (200).

15. Procédé selon l'une quelconque des revendications 1 à 13 dans lequel l'empilement (1) comprend en outre une couche d'intérêt secondaire (200') au-dessus de la couche tenseur (100), dans lequel le retrait de la portion de retrait (350) se fait également sélectivement à la couche d'intérêt secondaire (200'), le procédé comprenant en outre, préalablement à l'étape de retrait de la portion de retrait (350), une étape de structuration de la couche d'intérêt secondaire (200').

## Patentansprüche

1. Verfahren zur Herstellung einer dreidimensionalen Struktur, das die folgenden Schritte umfasst:
• Bereitstellen eines Stapels (1), der, gestapelt in einer vertikalen Richtung (Z), mindestens Folgendes umfasst:
i. ein Trägersubstrat (400),
ii. eine Opferschicht (300),
iii. eine Schicht von Interesse (200), die in allen Richtungen von einer Ebene senkrecht zur vertikalen Richtung (Z), der horizontalen Ebene (XY), durch eine Flanke (203) begrenzt ist,
iv. eine Spannschicht (100), die in allen Richtungen der horizontalen Ebene (XY) durch eine Flanke (103) begrenzt ist, wobei die Spannschicht (100) eine Restspannung σ₁₀₀ aufweist,
• Entfernen eines Abschnitts der Opferschicht, des Entfernungsabschnitts (350), selektiv von der Schicht von Interesse (200) und der Spannschicht (100), wobei der Entfernungsabschnitt (350) eine geschlossene Kontur in der Projektion in der horizontalen Ebene bildet, wobei sich der Entfernungsabschnitt (350) vollständig an einem seitlichen Abschnitt (250) der Schicht von Interesse (200) befindet, der sich von der gesamten Flanke (203) der Schicht von Interesse (200) erstreckt, wobei der Entfernungssabschnitt (350) so ausgeführt ist, dass ein Abschnitt der Opferschicht (300), der verbleibende Abschnitt (360), der sich an der Schicht von Interesse (200) und der Opferschicht (300) befindet, erhalten bleibt, wobei die Restspannung σ₁₀₀ der Spannschicht (100) so konfiguriert ist, dass sie eine Biegung der gesamten Schicht von Interesse (200) in einer einzigen Biegerichtung während des Schritts des Entfernens des Entfernungsabschnitts (350) bewirkt.

2. Verfahren nach dem vorhergehenden Anspruch, wobei die Flanke (203) der Schicht von Interesse (200) und die Flanke (103) der Spannschicht (100) jeweils eine im Wesentlichen elliptische oder im Wesentlichen kreisförmige Form in der Projektion in der horizontalen Ebene (XY) aufweisen.

3. Verfahren nach einem der vorhergehenden Ansprüche, wobei der verbleibende Abschnitt (360) eine Flanke (363) aufweist, die eine im Wesentlichen elliptische oder im Wesentlichen kreisförmige Form in der horizontalen Ebene (XY) aufweist.

4. Verfahren nach dem vorhergehenden Anspruch in Kombination mit Anspruch 2, wobei die Flanke (203) der Schicht von Interesse (200), die Flanke (103) der Spannschicht (100) und die Flanke (363) des verbleibenden Abschnitts (360) jeweils eine im Wesentlichen kreisförmige Form in der Projektion in der horizontalen Ebene (XY) aufweisen, wobei die Schicht von Interesse (200) in der horizontalen Ebene (XY) einen Durchmesser D₂₀₀ aufweist und der verbleibende Abschnitt (360) in der horizontalen Ebene (XY) einen Durchmesser D₃₆₀ aufweist, und wobei nach dem Entfernen des Entfernungsabschnitts (350) die Schicht von Interesse (200) eine Durchbiegung f₂₀₀ aufweist, mit f₂₀₀≥0,O5*(D₂₀₀-D₃₆₀), vorzugsweise f₂₀₀≥0,10*(D₂₀₀-D₃₆₀).

5. Verfahren nach einem der beiden vorhergehenden Ansprüche, wobei die Schicht von Interesse (200) in der horizontalen Ebene (XY) einen Durchmesser D₂₀₀ aufweist und der verbleibende Abschnitt (360) in der horizontalen Ebene (XY) einen Durchmesser D₃₆₀ aufweist, und wobei nach dem Entfernen des Entfernungsabschnitts (350) das Verhältnis D₂₀₀/D₃₆₀ größer als 2 ist, vorzugsweise größer als 3.

6. Verfahren nach den Ansprüchen 2 und 3 in Kombination, wobei die Flanke (203) der Schicht von Interesse (200), die Flanke (103) der Spannschicht (100) und die Flanke (363) des verbleibenden Abschnitts (360) jeweils eine im Wesentlichen elliptische Form in der Projektion in der horizontalen Ebene (XY) aufweisen, wobei die Schicht von Interesse (200) in der horizontalen Ebene (XY) eine kleine Achse D₂₀₀,y aufweist und der verbleibende Abschnitt (360) in der horizontalen Ebene (XY) eine kleine Achse D_{360,y} aufweist, und wobei nach dem Entfernen des Entfernungsabschnitts (350) die Schicht von Interesse (200) im Schnitt in einer Ebene senkrecht zur horizontalen Ebene (XY), die die kleine Achse der Schicht von Interesse 200 enthält, eine Durchbiegung f₂₀₀ aufweist, mit f₂₀₀≥0,05*(D_{200,y}-D_{360,y}), vorzugsweise f₂₀₀≥0,10*(D₂₀₀,_{y}-D_{360,y}).

7. Verfahren nach einem der vorhergehenden Ansprüche, das so konfiguriert ist, dass die Biegung der Schicht von Interesse (200) deren Flanke (203) näher an das Substrat (400) bringt.

8. Verfahren nach dem vorhergehenden Anspruch, das so konfiguriert ist, dass die Biegung der Schicht von Interesse (100) den Kontakt der Schicht von Interesse (200) mit dem Trägersubstrat (400) bewirkt.

9. Verfahren nach dem vorhergehenden Anspruch, das das Verkleben mindestens eines Teils der Schicht von Interesse (200) mit dem Trägersubstrat (400) umfasst.

10. Verfahren nach einem der Ansprüche 1 bis 6, wobei die Biegung der Schicht von Interesse (200) deren Flanke (203) vom Substrat (400) wegbewegt.

11. Verfahren nach einem der vorhergehenden Ansprüche, wobei |σ₁₀₀| > 500 MPa und vorzugsweise |σ₁₀₀| > 1000 MPa.

12. Verfahren nach einem der vorhergehenden Ansprüche, wobei die Schicht von Interesse (200) vor dem Entfernungsschritt eine Restspannung σ₂₀₀ aufweist, wobei |σ₂₀₀| ≤ 100 MPa.

13. Verfahren nach einem der vorhergehenden Ansprüche, wobei die Schicht von Interesse (200) nach dem Schritt des Entfernens des Entfernungsabschnitts (350) von der Opferschicht (300) eine Linse bildet.

14. Verfahren nach einem der vorhergehenden Ansprüche, das vor dem Schritt des Entfernens des Entfernungsabschnitts (350) von der Opferschicht (300) einen Schritt des Strukturierens der mindestens einen Schicht von Interesse (200) umfasst.

15. Verfahren nach einem der Ansprüche 1 bis 13, wobei der Stapel (1) ferner eine sekundäre Schicht von Interesse (200') oberhalb der Spannschicht (100) umfasst, wobei das Entfernen des Entfernungsabschnitts (350) auch selektiv an der sekundären Schicht von Interesse (200') erfolgt, wobei das Verfahren ferner vor dem Entfernen des Entfernungsabschnitts (350) einen Schritt des Strukturierens der sekundären Schicht von Interesse (200') umfasst.

## Claims

1. A method for manufacturing a three-dimensional structure comprising the following steps:
• supplying a stack (1) comprising, stacked in a direction called the vertical direction (Z), at least:
i. a support substrate (400),
ii. a sacrificial layer (300),
iii. a layer of interest (200) delimited in all directions of a plane perpendicular to the vertical direction (Z), called the horizontal plane (XY), by a sidewall (203),
iv. a tensor layer (100) delimited in all directions of the horizontal plane (XY) by a sidewall (103), the tensor layer (100) having a residual stress σ₁₀₀,
• removing a portion of the sacrificial layer, called the removal portion (350), selectively with respect to the layer of interest (200) and the tensor layer (100), the removal portion (350) forming a closed contour when projected onto the horizontal plane, the entirety of the removal portion (350) being located in line with a lateral portion (250) of the layer of interest (200) extending from the entirety of the sidewall (203) of the layer of interest (200), the removal of the removal portion (350) being carried out so as to retain a portion of the sacrificial layer (300), called the remaining portion (360), located in line with the layer of interest (200) and with the sacrificial layer (300),
the residual stress σ₁₀₀ of the tensor layer (100) being configured to cause bending of the entire layer of interest (200) in a single direction of bending during the step of removing the removal portion (350).

2. The method according to the preceding claim wherein the sidewall (203) of the layer of interest (200) and the sidewall (103) of the tensor layer (100) each have a substantially elliptical or substantially circular shape when projected onto the horizontal plane (XY).

3. The method according to any one of the preceding claims wherein the remaining portion (360) has a sidewall (363) having a substantially elliptical or substantially circular shape when projected onto the horizontal plane (XY).

4. The method according to the preceding claim as combined with claim 2 wherein the sidewall (203) of the layer of interest (200), the sidewall (103) of the tensor layer (100) and the sidewall (363) of the remaining portion (360) each have a substantially circular shape when projected onto the horizontal plane (XY), wherein the layer of interest (200) has a diameter D₂₀₀ in the horizontal plane (XY) and the remaining portion (360) has a diameter D₃₆₀ in the horizontal plane (XY), and wherein, after removing the removal portion (350), the layer of interest (200) has a deflection f₂₀₀, where f₂₀₀≥0.05*(D₂₀₀-D₃₆₀), preferably f₂₀₀≥0.10*(D₂₀₀-D₃₆₀).

5. The method according to any one of the two preceding claims wherein the layer of interest (200) has a diameter D₂₀₀ in the horizontal plane (XY) and the remaining portion (360) has a diameter D₃₆₀ in the horizontal plane (XY), and wherein, after removing the removal portion (350), the ratio D₂₀₀/D₃₆₀ is greater than 2, preferably greater than 3.

6. The method according to claims 2 and 3 combined wherein the sidewall (203) of the layer of interest (200), the sidewall (103) of the tensor layer (100) and the sidewall (363) of the remaining portion (360) each have a substantially elliptical shape when projected onto the horizontal plane (XY), wherein the layer of interest (200) has a minor axis D_{200,y} in the horizontal plane (XY) and the remaining portion (360) has a minor axis D_{360,y} in the horizontal plane (XY), and wherein, after removing the removal portion (350), the cross-section of the layer of interest (200) taken along a plane perpendicular to the horizontal plane (XY) and containing the minor axis of the layer of interest 200, has a deflection f₂₀₀, where f₂₀₀≥0.05*(D_{200,y}-D_{360,y}), preferably f₂₀₀≥0.10*(D_{200,y}-D_{360,y}).

7. The method according to any one of the preceding claims configured so that the bending of the layer of interest (200) brings its sidewall (203) closer to the substrate (400).

8. The method according to the preceding claim configured so that the bending of the layer of interest (100) causes the layer of interest (200) to come into contact with the support substrate (400).

9. The method according to the preceding claim comprising bonding at least part of the layer of interest (200) with the support substrate (400).

10. The method according to any one of claims 1 to 6 wherein the bending of the layer of interest (200) moves its sidewall (203) away from the substrate (400).

11. The method according to any one of the preceding claims wherein |σ₁₀₀| > 500 MPa and preferably |σ₁₀₀| > 1000 MPa.

12. The method according to any one of the preceding claims wherein, before the removal step, the layer of interest (200) has a residual stress σ₂₀₀ where |σ₂₀₀| ≤100 MPa.

13. The method according to any one of the preceding claims wherein the layer of interest (200), after the step of removing the removal portion (350) of the sacrificial layer (300), forms a lens.

14. The method according to any one of the preceding claims comprising, prior to the step of removing the removal portion (350) of the sacrificial layer (300), a step of structuring the at least one layer of interest (200).

15. The method according to any one of claims 1 to 13 wherein the stack (1) further comprises a secondary layer of interest (200') above the tensor layer (100), wherein the removal of the removal portion (350) is also carried out selectively with respect to the secondary layer of interest (200'), the method further comprising, prior to the step of removing the removal portion (350), a step of patterning the secondary layer of interest (200').
